# EUROPEAN PATENT SPECIFICATION

(11) **EP 1 856 718 B1**
(45) Date of publication and mention of the grant of the patent: **16.11.2016**
(21) Application number: 06783621.3
(22) Date of filing: 17.08.2006
(51) Int. Cl.: H01L 21/027

(54) **PATTERNING METHOD USING COATINGS CONTAINING IONIC COMPONENTS**
VERFAHREN ZUR MUSTERERZEUGUNG UNTER VERWENDUNG VON BESCHICHTUNGEN MIT IONISCHEN BESTANDTEILEN
PROCEDE DE FORMATION DE MOTIFS AU MOYEN DE REVETEMENTS CONTENANT DES COMPOSANTS IONIQUES

(30) Priority: 17.08.2005 KR 20050075193
(43) Date of publication of application: 21.11.2007
(73) Proprietor: LG CHEM, LTD., Seoul 150-721 (KR)
(72) Inventor: KIM, Dae-Hyun, Goyang-si, Gyeonggi-do, 411-370 (KR); KIM, Ji-Su, Daejeon Metropolitan City, 305-761 (KR); Shin, Dong-Myung, Daejeon 305-380 (KR); CHOI, Dong-Chang, Daejeon Metropolitan City, 305-721 (KR); CHOI, Kyung-Soo, Seoul, 134-843 (KR); JI, Ho-Chan, Daejeon Metropolitan City, 305-340 (KR); Cha, Geun-Young, Daejeon 305-380 (KR); KIM, Sung-Hyun, Daejeon Metropolitan City, 305-761 (KR)
(74) Representative: Hoffmann Eitle
(86) International application number: PCT/KR2006/003208
(87) International publication number: WO 2007/021130

(56) References cited:
- WO-A1-2005/069068
- JP-A- 9 073 091
- KR-A- 20010 089 324
- KR-A- 20010 098 621
- KR-A- 20050 016 441
- US-A- 4 698 907
- US-A- 5 037 504
- US-A- 5 286 415
- US-A- 5 871 672

## Description

### Technical Field

The present invention relates to a method of forming a pattern using a coating solution containing ionic components through a simple process at low cost so that precision of the pattern and transfer efficiency of the pattern are improved.

### Background Art

Generally, photolithography has been frequently performed using photoresists to form micropatterns used in display devices such as semiconductor circuit devices and LCDs. The photolithography includes coating, exposing, developing, washing, and curing steps. Even though the photolithography has an advantage in that a desired pattern can be precisely formed, it is disadvantageous in that many steps are performed, many types of materials are used to maximize the effect of the photoresist, and the large amount of photoresist is used in processes such as coating.

Recently, studies have been made to develop pattern transfer and pattern formation using a roll printing process in order to avoid the above-mentioned disadvantages of the photolithography. However, the current roll printing process is disadvantageous in that precision of the pattern and transfer efficiency of the pattern are significantly affected by a blanket and a clich constituting the roll printing device, a characteristic of the coating solution, and the process condition of the roll printing, and that undesirable large images remain after the transfer. Accordingly, there is a need to develop a method of forming a pattern so that the above-mentioned problems are avoided.

US 5 871 672 A discloses electronically conducting polymer films, US 5 286 415 A discloses an aqueous conductive polymer thick film-forming composition, JPH 09-073091 A relates to a device capable of accurately applying an electrified spacer along a specified pattern in the case of arranging the spacer between a pair of substrates of a liquid crystal display device so as to keep a space between the substrates constant,
US 4 698 907 A discloses a process for the manufacture of circuitry in the form generally known as circuit boards comprising the manufacture of a master pattern from a conductive layer and a superposed non-conductive layer which can receive an electrical charge, and WO 2005/069068 A1 discloses a method of forming transparent electrodes on a substrate.

### Disclosure of Invention

### Technical Problem

As described above, a known technology is problematic in that processability, cost, coating uniformity, and precision required to micropattern a material such as an electronic material are undesirable.

Accordingly, an object of the invention is to provide a method of forming a pattern, which has advantages of a simple process, low cost, and improved coating uniformity, precision, and transfer efficiency.

### Technical Solution

The invention provides a method of forming a pattern. The method includes a) applying coatings containing an ionic component having a positive or negative electric charge on a first side of a first substrate; b) bringing the first side of the first substrate into contact with an uneven portion of a first side of a second substrate to transfer a portion of the coatings that corresponds to projections of the second substrate from the first substrate onto the second substrate; and c) bringing the first side of the first substrate or the first side of the second substrate into contact with a print object to transfer the coatings onto the print object, wherein an electrode is provided on a second side, of the first substrate and the second substrate, which is opposite to the first side of the substrate, the electrode on the first substrate is electrified to have the same electric charge as the ionic component of the coatings in step (b) and/or in step (c), and the electrode on the second substrate is electrified to have the electric charge opposite to the electric charge of the ionic component of the coatings in step (b) and/or to have the same electric charge as the ionic component of the coatings in step (c).

The invention provides a method of forming a pattern of coatings. The method includes a) filling the coatings containing an ionic component having a positive or negative electric charge in a groove of a first side of a first substrate; b) bringing a first side of a second substrate into contact with the first side of the first substrate to transfer the coatings filled in the groove of the first substrate onto the second substrate; and c) bringing the first side of the second substrate into contact with a print object to transfer the coatings from the second substrate onto the print object, wherein an electrode is provided on a second side, of the first substrate and the second substrate, which is opposite to the first side of the substrate, the electrode on the first substrate is electrified to have the same electric charge as the ionic component of the coatings in step (b), and the electrode on the second substrate is electrified to have the electric charge opposite to the electric charge of the ionic component of the coatings in step (b) and/or to have the same electric charge as the ionic component of the coatings in step (c).

The invention provides a method of producing an electronic device using the above-mentioned method of forming the pattern. The method of producing the electronic device includes micropatterning an electronic material.

In connection with this, the electronic device is a component of an electromagnetic recording, imaging, or circuit apparatus.

The invention provides a coating composition for forming a pattern. The coating composition includes 50 to 95 wt.% of an electronic material based on a total weight of the composition, and 5 to 50 wt.% of a cationic or anionic component based on the total weight of the composition.

The electronic material may be selected from the group consisting of an optical ink, a metal solution for wires, a conductive paste, a resist, an adhesive, and a glue.

The cationic component or the anionic component may be one or more selected from the group consisting of a polymer that is polymerized using monovalent or divalent cationic or anionic monomers; a binder polymer selected from the group consisting of a copolymer that is polymerized using nonionic monomers and monovalent or divalent anionic or cationic monomers, and a derivative thereof; an organic or inorganic surfactant containing monovalent or divalent cationic or anionic components; and a monovalent or divalent cationic or anionic dye, a monovalent or divalent cationic or anionic pigment, and a complex thereof.

The invention provides a paste-type coating composition, of either cationic or anionic, for forming a pattern, which is produced by dispersing one or more selected from a conductive organic or inorganic material, alkali metal oxides, or conductive metal powder in a solvent.

As described above, the coating composition for forming the pattern may be the coating composition including the electronic material and the cationic or anionic component, or the paste-type ionic coating composition.

The invention provides an apparatus for forming a pattern. The apparatus includes a first substrate; a coater provided so that the coater is capable of being moved along a first side of a first substrate by a coater movement device to coat the first side of the first substrate using coatings containing an ionic component having a positive or negative electric charge; a second substrate provided so that the second substrate is capable of being moved in z-, x-, y-, and θ-axis directions based on a surface of the substrate by a substrate movement device to come into contact with the first side of the first substrate and having projections, which are formed on a first side of the second substrate, to which the coatings applied on the first side of the first substrate is transferred using the coater; and an electrode provided on the first substrate and the second substrate, wherein the first side of the second substrate comes into contact with a print object to transfer the coatings onto the print object, thereby forming the pattern on the print object.

The invention provides an apparatus for forming a pattern. The apparatus includes a first substrate having a first side on which a groove where coatings containing an ionic component having a positive or negative electric charge are filled is formed; a second substrate provided so that the second substrate is capable of being moved in z-, x-, y-, and θ-axis directions based on a surface of the substrate by a substrate movement device to come into contact with the first side of the first substrate, the second substrate having a first side onto which the coatings filled in the groove of the first substrate are transferred; and an electrode provided the first substrate and the second substrate, wherein the coatings filled in the groove of the first substrate are transferred onto the first side of the second substrate, and the first side of the second substrate comes into contact with the print object to transfer the coatings onto the print object, thereby forming the pattern on the print object.

The invention provides an apparatus for forming a pattern. The apparatus includes a first substrate is rotatably provided and has a roll shape; a coater that coats a surface of the first substrate using coatings containing an ionic component having a positive or negative electric charge; a second substrate having a first side, with projections to which the coatings applied on the first substrate are transferred using the coater; and an electrode provided on the first substrate and the second substrate, wherein the first substrate is rotated while being in contact with the first side of the second substrate to transfer the coatings applied on the surface of the first substrate onto the projections formed on the first side of the second substrate, and the coatings remaining on the first substrate or the coatings attached to the projections of the second substrate comes into contact with the print object to transfer the coatings onto the print object, thereby forming the pattern on the print object.

### Advantageous Effects

According to the method of the invention, it is possible to very precisely form a pattern with high transfer pattern efficiency. Therefore, in the case of when electronic materials are micropatterned using the method to produce parts of electronic recording, image, and circuit apparatuses, productivity of electronic devices is significantly improved.

### Brief Description of the Drawings

FIGS. 1 to 7 illustrate the formation of a pattern using a coating solution containing cationic components according to an embodiment of the invention;
FIGS. 8 and 9 illustrate the formation of a pattern using a coating solution containing anionic components according to another embodiment of the invention;
FIGS. 10 to 15 illustrate the formation of a pattern using a coating solution containing cationic components according to another embodiment of the invention;
FIGS. 16 to 21 illustrate the formation of a pattern using a coating solution containing cationic components according to another embodiment of the invention;
FIG. 22 illustrates a first movement device for vertically (z-axis) moving a second substrate and a second substrate support;
FIG. 23 illustrates a second movement device for moving the second substrate and the second substrate support right and left (y-axis), back and forth (x-axis), and θ-axially; and
FIGS. 24 and 25 schematically illustrate a coater and a coater movement device.

-Explanation of the signs that are the main part of the drawings-

- 1 :: second substrate electrode
- 2 :: second substrate
- 2a :: first side of the second substrate
- 2b :: second side of the second substrate
- 2c :: projection of uneven portion
- 3 :: coater
- 4 :: print object
- 4a :: first side of the print object
- 4b :: second side of the print object
- 5 :: print object electrode
- 6 :: first substrate electrode
- 7 :: first substrate support
- 8 :: first substrate
- 8a :: first side of the first substrate
- 8b :: second side of the first substrate
- 9,9a,9b,9c,9d :: coatings
- 10 :: cleaning substrate electrode
- 11 :: cleaning substrate
- 12 :: print object support
- 13 :: second substrate support
- 14 :: cleaning substrate support
- 20 :: support fixing frame
- 31 :: first control screw
- 32 :: movement support frame
- 33 :: second control screw
- 34 :: third control screw
- 35 :: stepping motor
- 40 :: coater mounting frame
- 41 :: linear motor

### Mode for the Invention

Hereinafter, the present invention will be described in detail referring to the accompanying drawings. However, the accompanying drawings and the following detailed description are illustrative but not intended to limit the present invention.

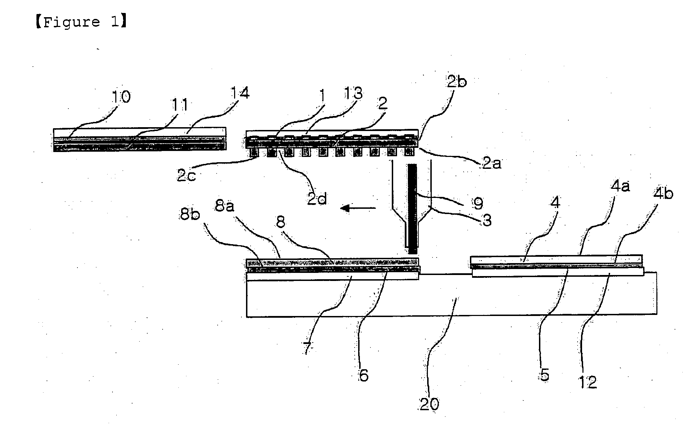

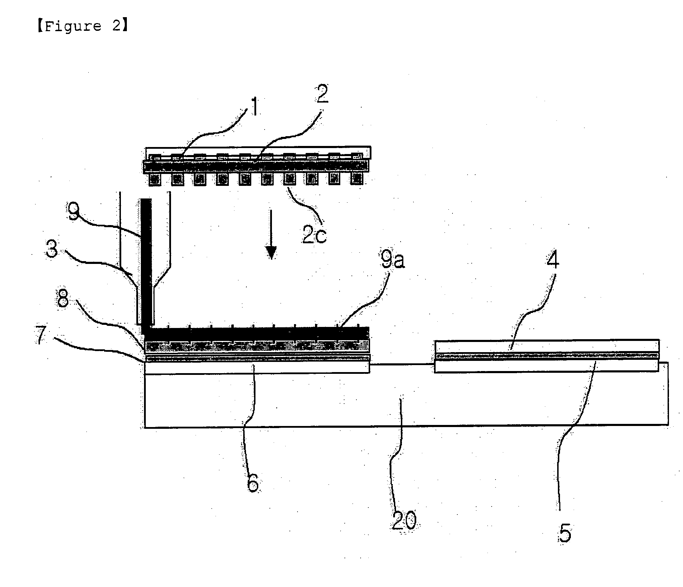

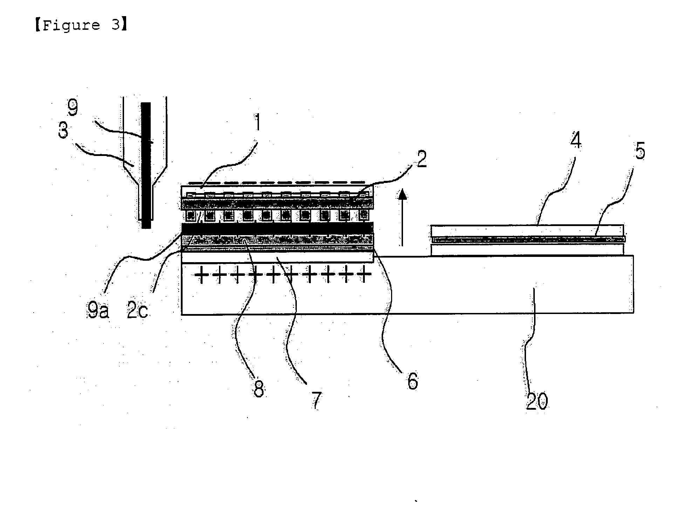

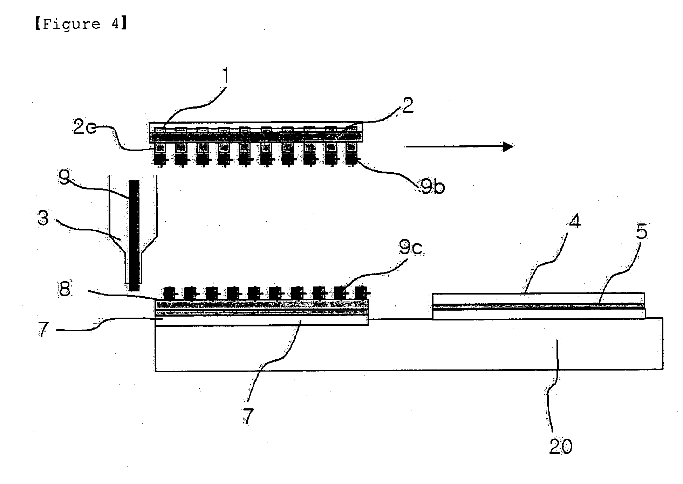

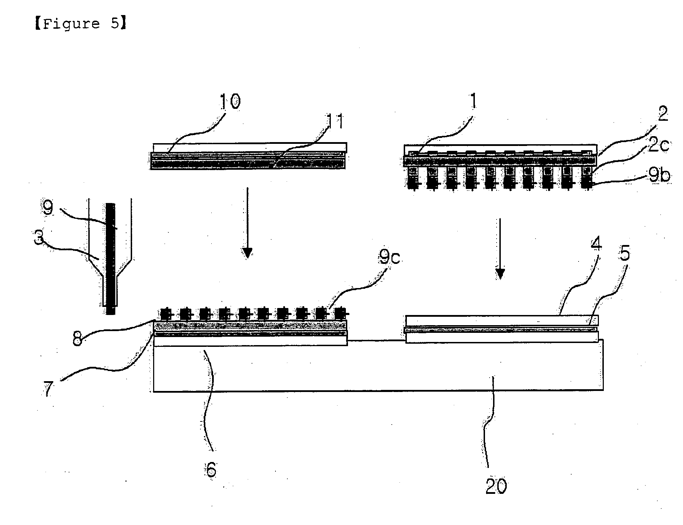

A first embodiment of the invention is shown in FIGS. 1 to 7. According to this embodiment, a method of forming a pattern according to the invention includes a) applying coatings 9 containing an ionic component having a positive charge on a first side 8a of a first substrate 8 (see FIGS. 1 and 2); b) bringing an uneven portion 2c and 2d having projections 2c and grooves 2d formed on a first side 2a of a second substrate 2 into contact with the coatings 9a applied on the first side 8a of the first substrate 8 to transfer a portion of the coatings 9a of the first substrate 8 which corresponds in position to the projections 2c of the second substrate 2 from the first substrate 8 onto the projections 2c of the second substrate 2 (see FIGS. 3 and 4); and c) bringing the coatings 9b formed on the projections 2c of the second substrate 2 into contact with a print object 4 to transfer the coatings 9b of the second substrate 2 onto the print object 4 (see FIGS. 5 to 7).

The coatings 9a, 9b, 9c, and 9d containing the ionic components are formed on the first sides 8a, 2a, and 4a of the first substrate 8, the second substrate 2, and the print object 4, and electrodes 6, 1, and 5 are formed on second sides 8b, 2b, and 4b that are opposite to the first sides 8a, 2a, and 4a.

As shown in FIG. 1, the first substrate 8, the second substrate 2, and the print object 4 may be fixed to supports 7, 13, and 12. In connection with this, the first substrate 8, the second substrate 2, and the print object 4 may be provided on first sides of the supports 7, 13, and 12, and the electrodes 6, 1, and 5 may be provided between the supports 7, 13, and 12, and the second sides of the first substrate 8, the second substrate 2, and the print object 4. The first substrate 8, the second substrate 2, and the print object 4 may be attached to the supports 7, 13, and 12 in vacuum.

The first substrate 8, the second substrate 2, and the print object 4 may be precisely moved vertically, right and left, and back and forth, and rotate in conjunction with the supports 7, 13, and 12 in order to maintain micro-alignment and flatness.

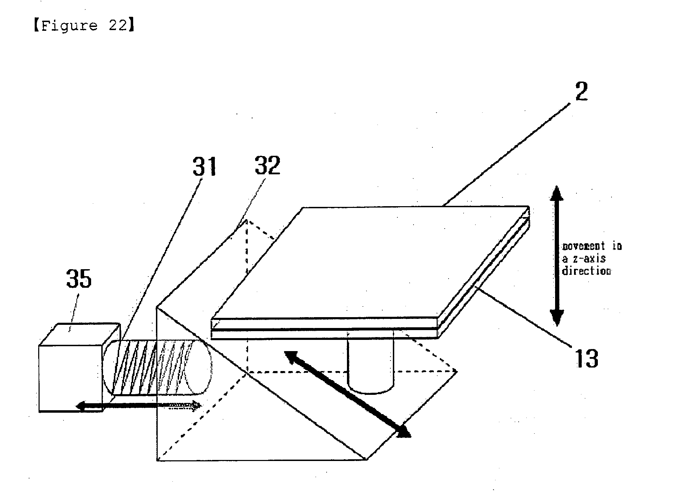

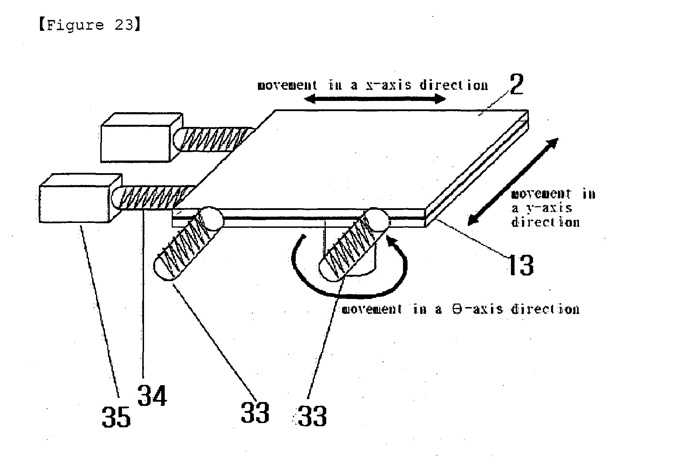

As shown in FIGS. 22 and 23, the second substrate 2 and the second substrate support 13 may be precisely moved vertically (z-axis; see FIG. 22), right and left (y-axis; see FIG. 23), back and forth (x-axis; see FIG. 23), and precisely rotate (0-axis; see FIG. 23) by a substrate movement device including a first movement device and a second movement device.

As shown in FIG. 22 that illustrating the first movement device of the second substrate 2 and the second substrate support 13 combined with each other, a pentahedral movement support frame 32 having an inclined side is threaded parallel to the base side, and a first control screw 31 is screwed to a threaded portion. Rotation of the first control screw 31 is controlled to vertically (z-axis) move the second substrate 2 and the second substrate support 13 along the inclined side of the movement support frame 32. For example, the first control screw 31 rotates to be screwed to the threaded portion so that the second substrate 2 and the second substrate support 13 are pushed by the inclined side of the movement support frame 32 to move toward the first substrate 8 or the print object 4.

As described above, the second substrate 2 and the second substrate support 13 which are combined with each other may slowly move toward or move away from the first substrate 8 or the print object 4 (vertically) using the first movement device. One first control screw 31 is shown in the drawing, but the number of the first control screw 31 is not limited thereto.

As shown in FIG. 23 that illustrating the second movement device, a screw line is precisely formed on a lateral surface of the second substrate support 13, and a second control screw 32 and a third control screw 33 are combined with the screw line. Rotation of the second control screw 32 and the third control screw 33 is controlled to move the second substrate 2 and the second substrate support 13, which are combined with each other, right and left (y-axis) and back and forth (x-axis). 0-axial movement (rotation) of the second substrate 2 and the second substrate support 13 which are combined with each other may be performed by relatively adjusting the second control screw 33 and the third control screw 34. Two second control screws 33 and two third control screws 34 are shown in the drawing, that is, a total of four screws are shown, but the numbers of the second control screws 33 and the third control screws 34 are not limited thereto.

A substrate movement device which is provided with the first and the second movement devices may further include a stepping motor 35 that is combined with at least one of the first control screw 31, the second control screw 33, and the third con trol screw 34 to rotate at least one of the first control screw 31, the second control screw 33, and the third control screw 34. The stepping motor 35 is driven to rotate the control screws 31, 33, and 34 so that positions of the second substrate 2 and the second substrate support 13 combined with each other are precisely controlled. Alternatively, the control screws 31, 33, and 34 may be manually rotated. The substrate movement device having the first movement device and the second movement device is not limited to the substrate movement device shown in the drawings.

Additionally, the substrate movement device that moves the second substrate 2 and the second substrate support 13 which are combined with each other may include a right and left movement unit for moving the second substrate 2 and the second substrate support 13, which are combined with each other, right and left, and a vertical movement unit for vertically moving the second substrate 2 and the second substrate support 13 which are combined with each other.

The right and left movement unit may include a frame where the second substrate 2 and the second substrate support 13 combined with each other are provided, and a linear motor that is connected to the frame to move the frame right and left. Alternatively, the right and left movement unit may be a driving arm.

The vertical movement unit may include a motor that generates power to vertically move the frame where the second substrate 2 and the second substrate support 13 combined with each other are provided, and a gear for transferring the power of the motor to the frame. That is, the second substrate 2 and the second substrate support 13 which are combined with each other may be vertically moved using a gear method. Alternatively, the vertical movement unit may include a motor that generates power to vertically move the frame where the second substrate 2 and the second substrate support 13 combined with each other are provided, and a piston that is connected to the frame so as to be movable in a cylinder by the power of the motor. That is, the second substrate 2 and the second substrate support 13 which are combined with each other may be vertically moved by a piston method using pressure. Alternatively, the vertical movement unit may be a driving arm.

Positions of the first substrate 8 and the print object 4 may be controlled through the same procedure as the position control of the above-mentioned second substrate 2, that is, using the device shown in FIGS. 22 and 23. The first substrate 8 and the print object 4 may be moved in all directions including x-, y-, z-, and θ-axis directions as the above-mentioned second substrate 2, and the positions of the first substrate 8 and the print object 4 may be independently controlled according to the above-mentioned variables (x-, y-, z-, and 0-axes).

Furthermore, the positions of the first substrate 8 and the print object 4 may be controlled using the right and left movement unit and the vertical movement unit of the above-mentioned second substrate 2.

The first substrate 8 and the print object 4 may be provided on a support fixing frame 20 that is provided at the position required in the process using the supports 7 and 12.

The support fixing frame 20 functions to support the first substrate 8 and the print object 4 from below, and is capable of being moved in all directions including x-, y-, z-, and θ-axis directions. Thus, it is convenient to simultaneously move the first substrate 8 and the print object 4 by the same distance.

The first substrate 8 and the print object 4 may be moved using a movement device including a conveyer and a driving arm. That is, after the first substrate 8 and the print object 4 are conveyed to the support fixing frame 20 using the conveyer, the first substrate 8 and the print object 4 are provided on the support fixing frame 20 using the driving arm, and fixed to the support fixing frame 20 using a vacuum absorption device. After the coatings 9d are transferred onto the print object 4, the print object 4 is separated from the print object support 12, moved on the conveyer using the driving arm, and conveyed.

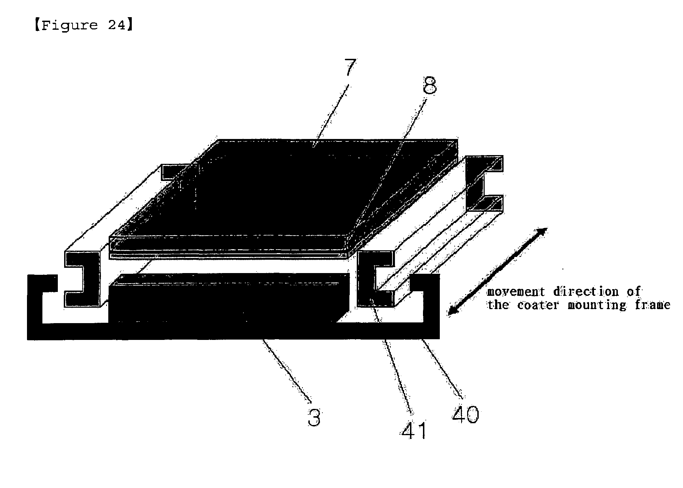

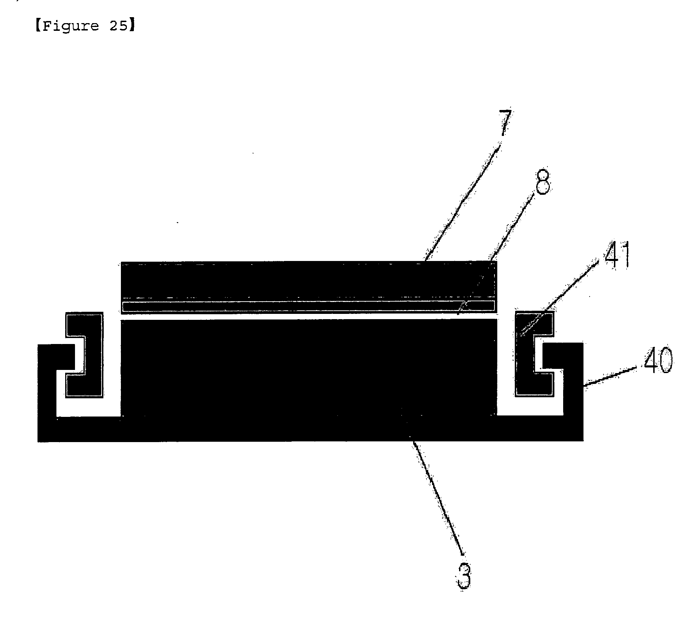

In connection with this, a coater 3 for coating the first substrate 8 using the coatings 9 may coat the first substrate 8 using the coatings 9 while being moved by a coater movement device. The coater 3 may coat the first substrate 8 using the coatings 9 while being moved by the coater movement device. As an example of the coater movement device, as shown in FIGS. 24 and 25, the coater movement device may include a coater mounting frame 40 where the coater 3 is mounted and a linear motor 41 for moving the frame 40 right and left, in which the coater 3 is provided. Alternatively, the coater may be moved using the driving arm.

Steps of a method according to a first embodiment of the invention will be described.

In step (a), as shown in FIGS. 1 and 2, the coatings 9 that contain the ionic component having the positive charge may be applied on the first side 8a of the first substrate 8 using the coater 3.

Examples of the coater 3 for applying the coatings 9 include, but are not limited to a capillary-type or slit-type slot coater.

In the first embodiment, the coatings 9 containing the cationic component are used. However, in the invention, both the cationic component and the anionic component may be used as the ionic component contained in the coatings 9. Any material may be used as the coatings as long as the material contains the cationic component or the anionic component.

In the invention, examples of the coatings containing the ionic component include, but are not limited to an optical ink used to form a color filter for TFT-LCD, a metal solution for wires used to form electronic circuits, a functional resin such as a conductive paste or a resist, and an adhesive and a glue capable of satisfying precision patterning.

In the invention, the coatings containing the ionic component may be a coating composition for forming patterns that includes 50 to 95 wt.% of an electronic material based on the total weight of the composition, and 5 to 50 wt.% of a cationic or anionic component based on the total weight of the composition. In order to improve the coatings property of the coatings applied on an upper surface of the first substrate 8, a fluorine- or silicon-based surfactant may be further added as a leveling agent or a wetting agent. Additionally, an adhesion promoter or an antifoaming agent may be further added to improve adhesion strength to the print object 4.

Materials that are extensively applied to electronic machines, for example, resistor materials such as semiconductors and magnetic materials, contact materials, dielectric materials, and conductive materials, may be used as the electronic material. Examples of the electronic material include an optical ink, a metal solution for wires such as PCBs (printed circuit board), a conductive paste, a resist, an adhesive, and a glue.

The cationic component or the anionic component may be one or more selected from the group consisting of a polymer that is polymerized using monovalent or divalent cationic or anionic monomers; a binder polymer selected from the group consisting of a copolymer that is polymerized using nonionic monomers and monovalent or divalent anionic or cationic monomers, and a derivative thereof; an organic or inorganic surfactant containing monovalent or divalent cationic or anionic components; a monovalent or divalent cationic or anionic dye, a monovalent or divalent cationic or anionic pigment, and a complex thereof.

As described above, a coating composition for forming patterns that includes the electronic material and the cationic or anionic component, or a paste-type ionic coating composition for forming patterns may be used as the coating composition for forming the patterns. For example, the paste-type cationic or anionic coating composition for forming the patterns that is produced by dispersing one or more selected from a conductive organic or inorganic material, alkali metal oxides, or conductive metal powder in a solvent may be used. In order to improve the coatings property of the coatings applied on an upper surface of the first substrate 8, a fluorine- or silicon-based surfactant may be further added as a leveling agent or a wetting agent. Additionally, an adhesion promoter or an antifoaming agent may be further added to improve adhesion strength to the print object 4.

In the above-mentioned embodiment, it is preferable that a substrate having relatively lower adsorption strength to the coatings 9 be used as the first substrate 8 as compared to the second substrate 2 or the print object 4. In the case of when the second substrate 2 or the print object 4 is formed of glass, it is preferable that the first substrate 8 be formed of the material having low surface energy such as silicon rubber. In the case of when the hard plastic material, such as polyethylene terephthalate (PET) or nylon, or glass is used, the surface 8a thereof may be coated with hydrophobic material or hydrophobic surface treatment may be performed using the plasma to form the material having the relatively lower adsorption strength to the coatings 9.

Furthermore, the first substrate 8 may include a first layer formed of soft silicon rubber on which the coatings 9a are applied and a second layer formed of hard PET material which comes into contact with the first substrate support 7. The first substrate 8 may be fixed to the first substrate support 7 including hard material that is little worn, such as stainless steel, by a vacuum adsorption device for fixing wafers. As a representative example of silicon rubber that is capable of being used to produce the first substrate 8, there is polydimethylsiloxane. Further, any elastomer may be used to form the first substrate 8 as long as the elastomer deforms by external force and is restored to the original state after a predetermined time to form a system where energy is conserved like polyurethanes. For example, a PDMS crude liquid and a curing agent are mixed and then cured on a surface plate to produce the first substrate 8. In connection with this, a spin-type or slit-type coater may be used to obtain a constant thickness. Preferably, the blanket has hardness of rockwell C scale 20 to 69 after the curing, and the hardness may be controlled by denseness of a polymer chain which is to be cured, or by changing the amount of polyurethanes added to PDMS in the case of when polyurethanes are added to PDMS.

It is preferable that a first substrate electrode 6 be formed on the second side 8b of the first substrate 8 having the corresponding area to the entire surface of the first substrate 8.

In the above-mentioned embodiment, it is preferable that a substrate having relatively higher adsorption strength to the coatings 9 be used as the second substrate 2 as compared to the first substrate 8. More preferably, the second substrate 2 have the adsorption strength to the coatings 9 between the adsorption strength of the first substrate 8 and the adsorption strength of the print object 4.

Examples of the material of the second substrate 2 include, but are not limited to metal such as aluminum and stainless steel, hard plastic material such as polyethylene terephthalate (PET) or acryl, and a silicon compound such as glass. A pattern having the depth of 0.1 to 100 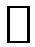 is formed on the second substrate 2. When the pattern is precisely formed, the pattern may be sophisticated. An aspect ratio of the width and the depth of the pattern is preferably 5:1 to 0.01:1. It is difficult to process the pattern and a risk of breaking during the printing is increased as the aspect ratio of the pattern is increased.

In order to control the adsorption strength of the second substrate 2 to the coatings 9 to be within the above-mentioned range, projections 2c of the first side 2a of the second substrate 2 may be subjected to surface reformation using material having the characteristics of silicon- or fluorine-based surfactants or using a hydrophobic or hydrophilic treating process including plasma treatment.

A second substrate electrode 1 is formed on the second side 2b of the second substrate 2. In order to improve precision of the pattern and transfer efficiency of the pattern, it is preferable that the second substrate electrode 1 have the pattern corresponding in shape to the projections 2c of the uneven portion 2c and 2d formed on the first side 2a of the second substrate 2.

As shown in FIG. 3, in step (b), the second substrate 2 comes close to the first side 8a of the first substrate 8 to bring the projections 2c of the second substrate 2 into contact with the coatings 9a formed on the first side 8a of the first substrate 8, thereby transferring a portion of the coatings 9a formed on the first side 8a of the first substrate 8 onto the projections 2c of the second substrate 2. As shown in FIG. 4, after the transfer is finished, the second substrate 2 is separated from the first substrate 8.

A coating portion 9b of the coatings 9a formed on the first side 8a of the first substrate 8 is transferred onto the projections 2c of the second substrate 2, and the residual coating portion 9c remains on the first side 8a of the first substrate 8.

In this step, voltage of 5 to 220 V that is typically used as electrodeposition voltage is applied from a power supplier (not shown) to the first substrate electrode 6 of the first substrate 8 so that the first substrate electrode of the first substrate 8 is electrified to have the same electric charge as the ionic component of the coatings 9a, thereby improving transfer efficiency of the coatings 9a from the first substrate 8 on the second substrate 2. Additionally, voltage is applied to the second substrate electrode 1 of the second substrate 2 so that the second substrate electrode 1 is electrified to have the electric charge opposite to the electric charge of the ionic component of the coatings 9a, thereby improving transfer efficiency of the coatings 9a.

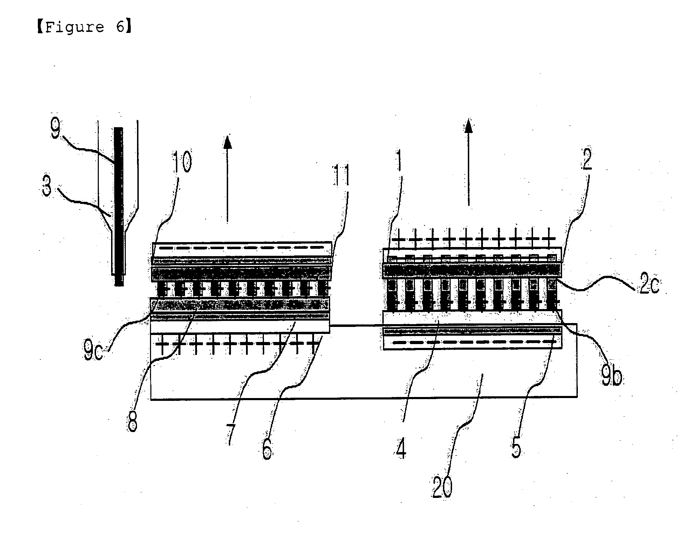

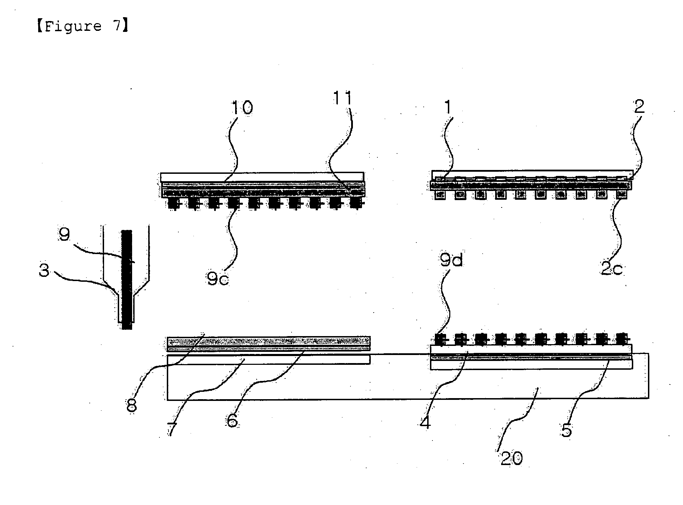

Subsequently, as shown in FIGS. 5 and 6, in step (c), the second substrate 2, to the projections 2c of which the coatings 9b are attached, comes close to the first side 4a of the print object 4 so as to bring the coatings 9b of the second substrate 2 into contact with the first side 4a of the print object 4, thereby transferring the coatings 9b attached to the projections 2c of the second substrate 2 onto the first side 4a of the print object 4. As shown in FIG. 7, after the transfer is finished, the second substrate 2 is separated from the first side 4a of the print object 4.

Accordingly, as shown in FIG. 7, the coatings 9b attached to the projections 2c of the second substrate 2 is transferred onto the first side 4a of the print object 4 so as to provide the coatings 9d on the first side 4a of the print object 4 to form a predetermined pattern.

In this step, high voltage is applied to the second substrate electrode 1 of the second substrate 2 so that the second substrate electrode 1 is electrified to have the same electric charge as the ionic component of the coatings 9b, thereby improving transfer efficiency of the coatings 9b on the print object 4. Additionally, high voltage is applied to the print object electrode 5 so that the print object 4 is electrified to have the electric charge opposite to the electric charge of the ionic component of the coatings 9b, thereby improving transfer efficiency of the coatings 9b.

In the invention, the material having the hard surface that is capable of being used as the substrate of electronic materials and display materials, such as glass, and the polymer material that has the flexible surface, such as polyethylene, polypropylene, or polyvinyl, may be used as the print object 4. Examples of the material of the print object include, but are not limited to a flexible plastic material such as polyester and PET applied to e-papers or flexible displays; a hard plastic material of polyurethane or epoxy applied to substrates of PCBs; or glass.

It is preferable that the pattern of the coatings 9d transferred onto the print object 4 be fixed to the print object 4 using heat curing and/or photocuring processes. If the pattern of the coatings 9d is solidified, the pattern can endure external physical and chemical changes.

When the coatings 9d are fixed to the print object 4, a convection oven, a hot plate, or a UV exposing machine may be used. In the case of when UV (ultraviolet) curing is used, the curing using the UV exposure and baking may be performed to fix the coatings. All processes known in the art may be applied to fix the coatings 9d transferred on the print object 4.

Meanwhile, in the first embodiment, the electrodes 6, 1, and 5 are provided on all of the first substrate 8, the second substrate 2, and the print object 4, which is preferable to improve the precision of the pattern and the transfer efficiency of the pattern. However, even if the electrode is provided on one or more of the first substrate 8, the second substrate 2, and the print object 4, it is possible to improve the precision of the coating pattern and the transfer efficiency of the coating pattern.

In the first embodiment, step (d) of using a cleaning substrate 11 may be further performed to remove the coatings 9c remaining on the first substrate 8 (see FIGS. 5 to 7).

In step (d), as shown in FIGS. 5 and 6, the cleaning substrate 11 comes close to the first substrate 8 on which the coatings 9c are formed to come into contact with the coatings 9c of the first substrate 8, thereby transferring the coatings 9c of the first substrate 8 onto the cleaning substrate 11. As shown in FIG. 7, after the transfer is finished, the cleaning substrate 11 is separated from the first substrate 8.

As shown in FIG. 7, the coatings 9c are transferred from the first substrate 8 onto the cleaning substrate 11 to be removed from the first substrate 8.
Step (d) and step (c) may be simultaneously performed. While step (d) is performed, high voltage is applied to the first substrate electrode 6 so that the first substrate electrode 6 is electrified to have the same electric charge as the ionic component of the coatings 9c, thereby improving removal efficiency of the coatings 9c.

Additionally, a cleaning substrate electrode 10 may be further provided on a side of the cleaning substrate 11 that is opposite to the side to which the coatings 9c are attached, and a cleaning substrate support 14 may be further provided on the cleaning substrate electrode 10. In connection with this, the cleaning substrate 11 may be attached to the cleaning substrate support 14 in vacuum. Positions of the cleaning substrate 11 and the cleaning substrate support 14 may be controlled using the same procedure as the above-mentioned position control of the second substrate 2, that is, using the device shown in FIGS. 22 and 23. The cleaning substrate 11 and the cleaning substrate support 14 may be moved in all directions including x-, y-, z-, and θ-axis directions as the above-mentioned second substrate 2, and the positions of the cleaning substrate 11 and the second substrate 2 may be independently controlled according to the above-mentioned variables (x-, y-, z-, and θ-axes). Furthermore, the position of the cleaning substrate 11 combined with the cleaning substrate support 14 may be controlled using the right and left movement unit and the vertical movement unit of the above-mentioned second substrate 2. Accordingly, the cleaning substrate 11 may be precisely moved vertically, right and left, back and forth, and rotate in conjunction with the cleaning substrate support 14 in order to maintain micro-alignment and flatness.

When step (d) is performed, high voltage is applied to the cleaning substrate electrode 10 so that the cleaning substrate electrode 10 is electrified to have the electric charge opposite to the electric charge of the ionic component of the coatings 9c, thereby improving removal efficiency of the coatings 9c.

Examples of the cleaning substrate 11 may include a substrate that is formed of an inorganic material having relatively high adsorption strength to the coatings 9c, such as glass, or a hard plastic material such as hydrophilically surface-treated PET or acryl. Preferably, the cleaning substrate 11 is formed of glass.

In the invention, Ag, Al, Pd, Au, Cu, Ti, and Ni may be used as the material of the electrode formed on the first substrate 8, the second substrate 2, the print object 4, or the cleaning substrate 11.

The electrodes 6, 1,5, and 10 that are formed on the second sides 8b, 2b, and 4b of the first substrate 8, the second substrate 2, the print object 4, or the cleaning substrate 11 may be formed using processes such as thermal evaporation, E-beam evaporation, sputtering, and chemical vapor deposition (CVD).

Additionally, in the case of when the second substrate electrode 1 having the corresponding shape to the uneven portion 2c and 2d is formed on the second side 2b of the second substrate 2 including the first side 2a having the uneven portion 2c and 2d, the formation may be performed by thermal evaporation using a mask, E-beam evaporation, sputtering, chemical vapor deposition, or negative- or positive-type photolithography.

However, the invention is not limited to the above-mentioned electrode materials and formation processes, and the materials and the processes known in the art may be used.

The electrification of the electrodes may be performed using the process known in the art so that the electrodes have the electric charge that is identical or opposite to the coatings. For example, the electrification may be controlled using a controller.

The first substrate electrode 6 is connected to a high voltage power supplier (not shown) to which a switch is connected to control the power supply so as to form a first circuit. Additionally, the second substrate electrode 1 is connected to another high voltage power supplier to which a switch is connected to control the power supply so as to form a second circuit.

In the case of when the first circuit including the first substrate electrode 6 and the second circuit including the second substrate electrode 1 are independently formed, the switch of the first circuit and the switch of the second circuit are turned off so that the first circuit and the second circuit act as open circuits in step (a) shown in FIG. 2. In step (b) shown in FIG. 3, the switch of the first circuit and the switch of the second circuit are turned on at the same time the projections 2c of the second substrate 2 come into contact with the coatings 9a. Accordingly, the first circuit including the first substrate electrode 6 and the second circuit including the second substrate electrode 1 act as closed circuits, thereby allowing a current to flow.

In the case of when the coatings 9a contain the cationic component, the direction of the current flow is controlled so that the second substrate electrode 1 has the negative electric charge and the first substrate electrode 6 has the positive electric charge.

Meanwhile, in the case of when the coatings 9a contain the anionic component, the direction of the current flow is controlled so that the second substrate electrode 1 has the positive electric charge and the first substrate electrode 6 has the negative electric charge.

Alternatively, both the electrodes 6 and 1 may be connected to one high voltage power supplier to which the switch is connected to control the power supply so as to form a single circuit.

In the case of when the second substrate electrode 1 and the first substrate electrode 6 form the single circuit, the switch is turned off so that the single circuit acts as the open circuit in step (a) shown in FIG. 2, and the switch is turned on at the same time the projections 2c of the second substrate 2 come into contact with the coatings 9a in step (b) shown in FIG. 3. Accordingly, the single circuit including the second substrate electrode 1 and the first substrate electrode 6 acts as the closed circuit, thereby allowing the current to flow.

In connection with this, in the case of when the coatings contain the cationic component, the direction of the current flow is controlled so that the second substrate electrode 1 has the negative electric charge and the first substrate electrode 6 has the positive electric charge. In the case of when the coatings 9 contain the anionic component, the direction of the current flow is reversely changed.

Furthermore, in the step of transferring the pattern which is transferred onto the first substrate 8 or the second substrate 2 on the print object 4 and in the step of transferring the coatings which remain on the first substrate 8 or the second substrate 2 onto the cleaning substrate 11, the print object electrode 5 and/or the cleaning substrate electrode 10 may be electrified so as to have the negative or positive electric charge using the above-mentioned process.

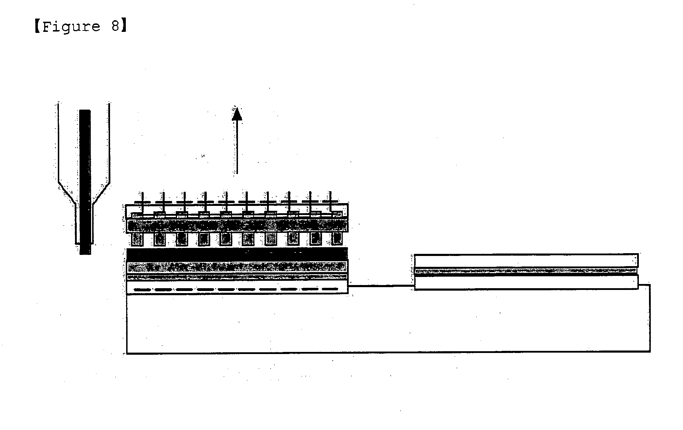

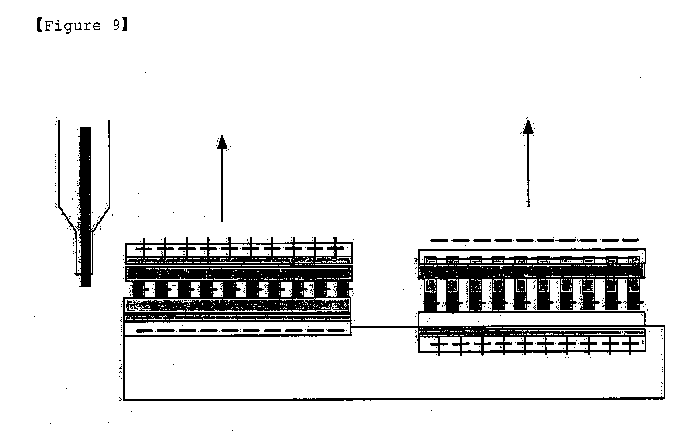

A second embodiment of the invention is shown in FIGS. 8 and 9. The second embodiment is the same as the first embodiment except that the coatings contain the ionic component having the negative electric charge.

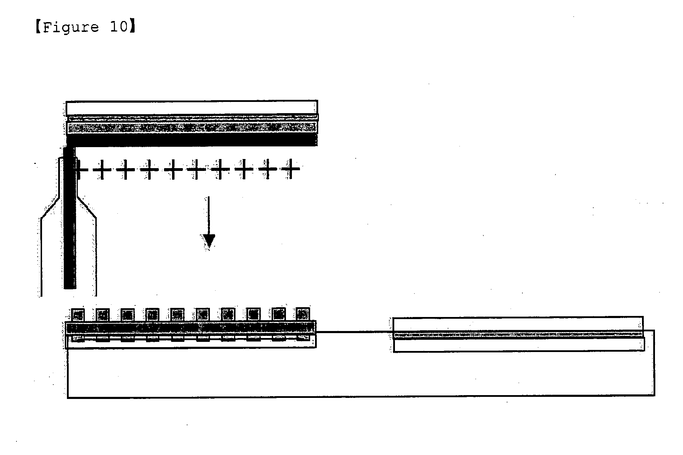

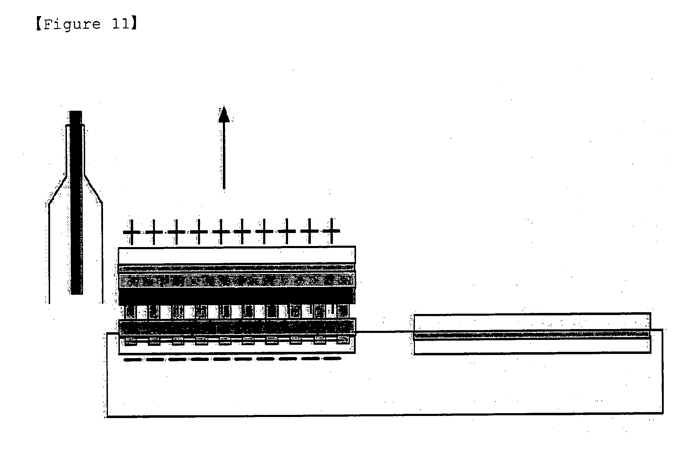

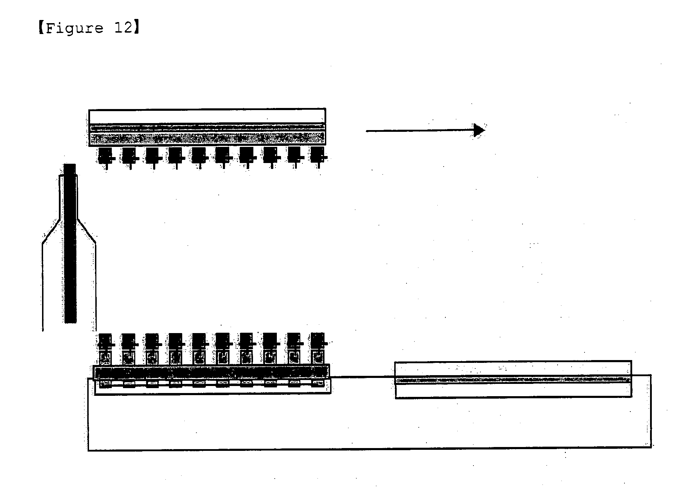

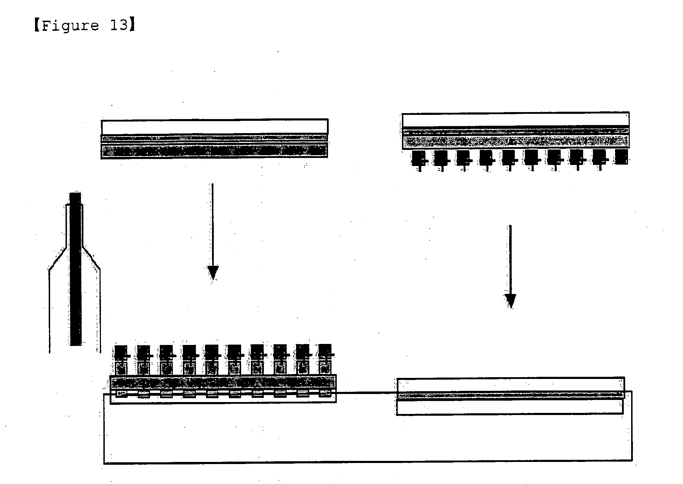

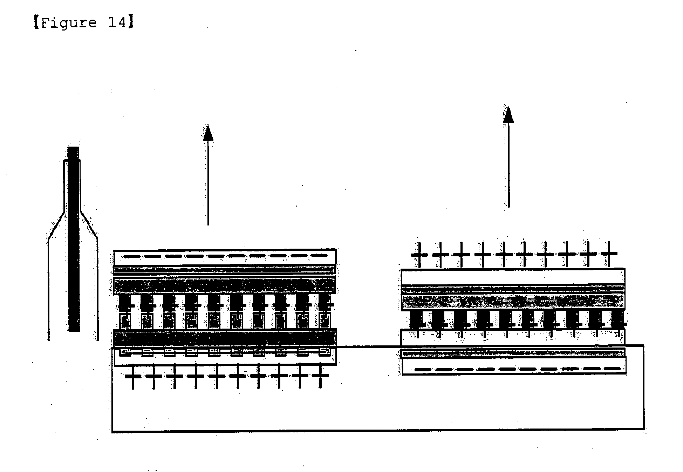

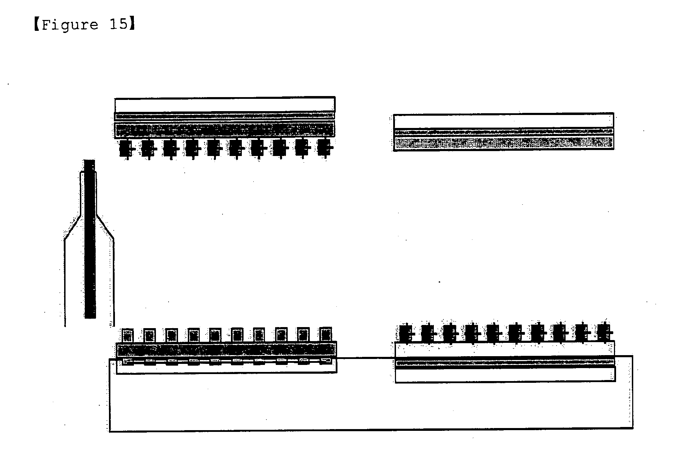

A third embodiment not parts of the invention is shown in FIGS. 10 to 15. In the
embodiment, the method of forming the pattern according to the invention includes a) applying the coatings containing the ionic component having the positive electric charge on the first side of the first substrate (see FIG. 10); b) bringing the coatings applied on the first side of the first substrate into contact with the uneven portion formed on the first side of the second substrate so that a portion of the coatings of the first substrate which corresponds in position to the projections of the second substrate is transferred from the first substrate to the second substrate (see FIGS. 11 and 12); and c) bringing the coatings formed on the first side of the first substrate into contact with the print object so that the coatings of the first substrate is transferred onto the print object (see FIGS. 13 to 15).

In the third embodiment, the electrodes are provided on the first substrate, the second substrate, and the second side of the print object that is opposite to the first side thereof.

The third embodiment is the same as the above-mentioned first embodiment except that the coatings are directly transferred from the first substrate onto the print object in step (c). In the third embodiment, high voltage is applied to the first substrate electrode so that the first substrate electrode is electrified to have the same electric charge as the ionic component of the coatings in step (c), thereby improving transfer efficiency.

The above-mentioned first to third embodiments show the case of when the first substrate and the second substrate are a flat plate. However, in the invention, the first substrate and/or the second substrate may have the roll shape. However, the use of the flat plate may still more improve the precision of the pattern, transfer efficiency of the pattern, and the pattern forming rate.

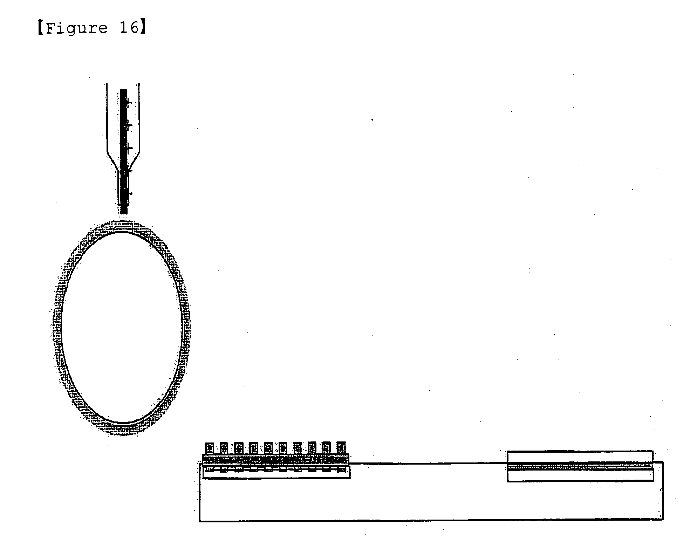

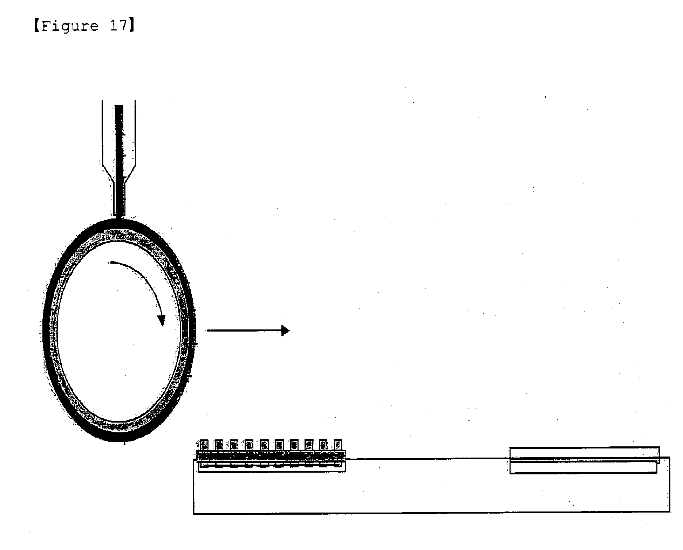

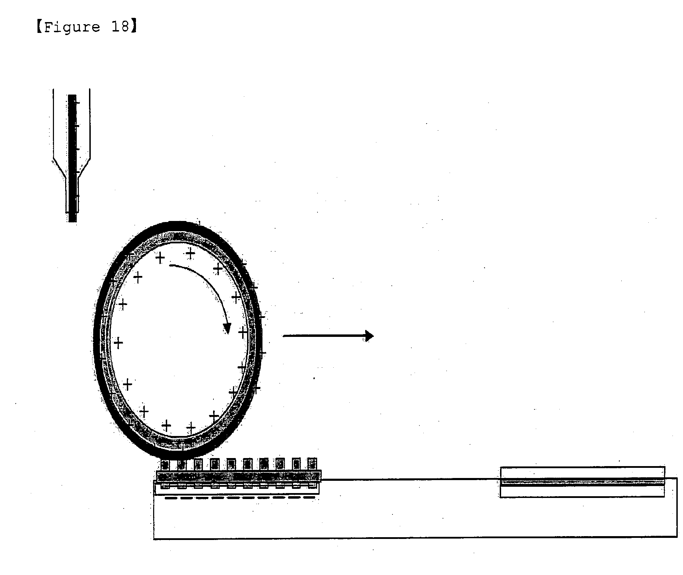

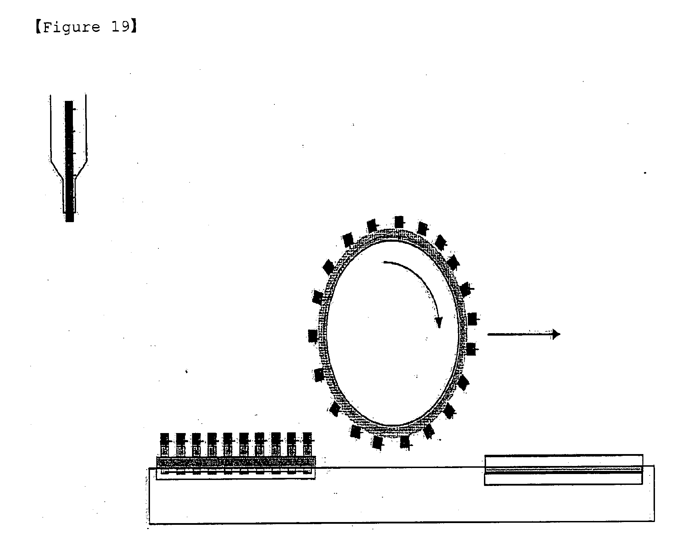

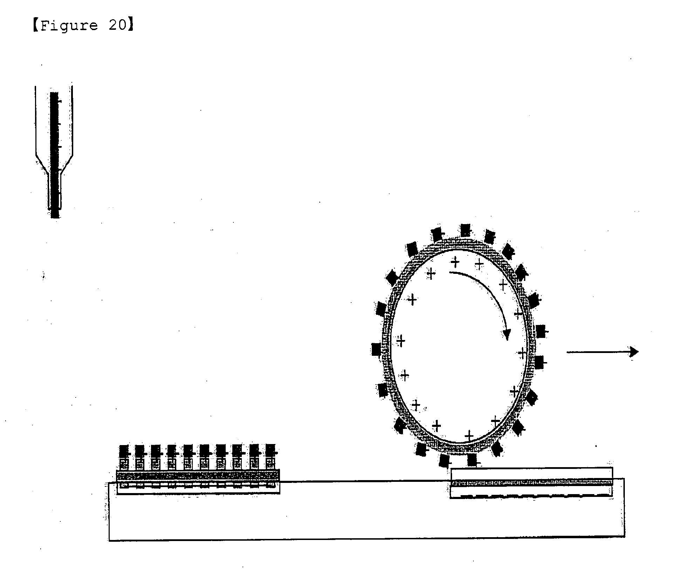

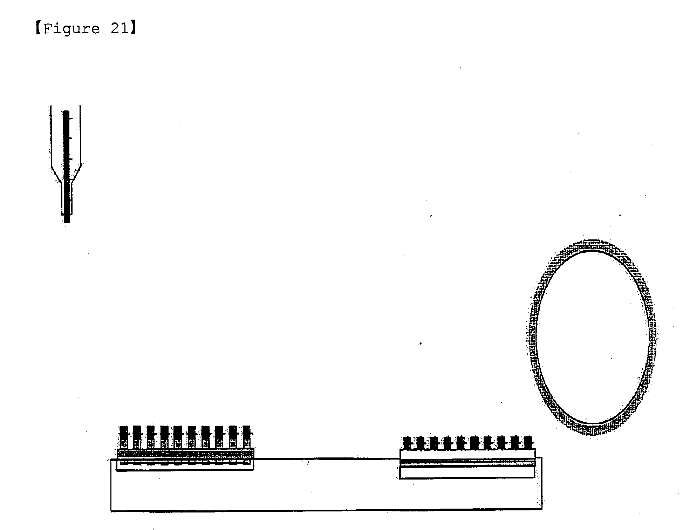

A fourth embodiment of the invention is shown in FIGS. 16 to 21. The fourth embodiment is the same as the above-mentioned first embodiment except that the first substrate has the roll shape.

The method according to a fifth embodiment of the invention includes a) filling the coatings containing the ionic component having the positive or negative electric charge in the groove of the first side of the first substrate, b) bringing the first side of the second substrate into contact with the first side of the first substrate to transfer the coatings filled in the groove of the first substrate onto the second substrate, and c) bringing the first side of the second substrate into contact with the print object to transfer the coatings from the second substrate onto the print object. The electrode is provided on the second side of the first substrate and the second substrate that is opposite to the first side thereof.

The electrode provided on the first substrate is electrified so as to have the
same electric charge as the ionic component of the coatings in step (b). Additionally, the electrode on the second substrate may be electrified so as to have the electric charge opposite to the electric charge of the ionic component of the coatings in step (b) and/or to have the same electric charge as the ionic component of the coatings in step (c).

In the fifth embodiment, the electrodes are provided on all of the first substrate,
the second substrate, and the print object. However, the precision of the coating pattern and the transfer efficiency of the pattern can be improved even though the electrodes are provided on at least one of the first substrate, the second substrate, and the print object. A portion of this embodiment that is not mentioned may be realized referring to the corresponding description of the first embodiment.

Examples of the optimum device that is capable of being applied to the invention may include a device for selectively coating a sealant that is used in a color filter process for LCDs (liquid crystal display), a TFT (thin film transistor) circuit process for LCDs, a PDP (plasma display panel) filter process, a PDP upper and lower plate electrode process, a device for producing a PDP partition, a catalyst micropatterning device for electrochemical deposition, a transfer device for semiconductors, a selective hydrophilic and hydrophobic treatment device, a flexible display, or an E-paper.

In the invention, micropatterns that are used in electronic materials are efficiently transferred using the above-mentioned processes to produce parts of circuit apparatuses such as wires, display devices such as LCDs, OLEDs, PDPs, E-papers, and flexible displays, electromagnetic recording devices, and circuit apparatuses such as wires.

According to the method of the invention, it is possible to significantly improve the precision of the pattern and the transfer efficiency of the pattern.

In the method of the invention, in the case of when the substrate used to form the coating pattern does not have the roll shape but the flat plate shape, a native stone such as marble, an inorganic material such as ceramics, or stainless steel that is little deformed by gravity or the load thereof is processed to form a thin structure, thereby producing the supports 7, 13, and 12 of the substrate. Accordingly, durability of the substrate may be still more improved. In the marble or ceramics, there is no deformation unlike metal or polymer material.

Furthermore, in the method of the invention, in the case of when the substrate does not have the roll shape but the flat plate shape, it is preferable that the surfaces come into vertical contact with the substrate. Further, in the case of when the substrate does not have the roll shape but the flat plate shape, it is preferable that uniform pressure (10⁻² to 10³ Mpa) be applied to the contact surfaces of the first substrate and the second substrate, or the contact surfaces of the first substrate or the second substrate and the print object. In the case of when the first substrate and the second substrate having the uneven portion are pressed at excessively high pressure, the first substrate may come into contact with the bottom of the second substrate having the uneven portion. The dissolution regarding determination of the pressure must be 1/1000 or more of the allowable minimum pressure. When the first substrate comes close to the second substrate, or when any one of the first substrate and the second substrate comes close to the print object, it is preferable to perform the pressing while alignment is precisely performed using the pressure.

In this case, it is possible to form the uniform coating pattern having the high precision on the print object. In the invention, electrical and optical compression sensing processes may be performed to apply uniform pressure to the entire contact surface.

With respect to the electric process, a piezodielectric sensor[piezodielectric transducer(PZT) or piezodielectric quartz crystal] may be used. For example, the piezodielectric sensor or a laser interferometer is provided on at least two portions, and preferably three portions, of the first substrate and the second substrate to electrically convert the pressure resulting from the pressing, thereby applying the uniform pressure to the entire contact surface.

Additionally, with respect to the optical process, the laser interferometer may be used. For example, the piezodielectric sensor or the laser interferometer may be provided on at least two portions, and preferably three portions, of the first substrate and the second substrate to apply the uniform pressure to the entire contact surface. In the case of the laser interferometer, an access distance may be set to the nanometer (nm) level. The access distance of a few tens nanometers may be detected using a Moire pattern in the laser interferometer. Detection precision is increased as an interval of precision gratings having the cycle used in interference is reduced.

According to the method of the invention, it is possible to precisely form the uniform pattern of the coatings on the large surface. The above-mentioned piezodielectric sensor and the laser interferometer have not been used in the art. However, the a piezodielectric sensor and the laser interferometer, which are typically used in industrial processes of other fields, may be applied to the method of the invention.

## Claims

1. A method of forming a pattern, the method comprising the steps of:
a) applying coatings (9, 9a, 9b, 9c, 9d) containing an ionic component having a positive or negative electric charge on a first side (8a) of a first substrate (8);
b) bringing the first side (8a) of the first substrate (8) into contact with an uneven portion of a first side (2a) of a second substrate (2) to transfer a portion of the coatings (9, 9a, 9b, 9c, 9d) that corresponds to projections (2c) of the second substrate (2) from the first substrate (8) onto the second substrate (2); and
c) bringing the first side (2a) of the second substrate (2) into contact with a print object (4) to transfer the coatings (9, 9a, 9b, 9c, 9d) onto the print object (4),
wherein an electrode (6, 1) is provided on a second side (8b, 2b), of the first substrate (8) and the second substrate (2), which is opposite to the first side (8a, 2a) of the substrate (8, 2),
wherein the electrode (1) on the second substrate (2) is electrified to have the electric charge opposite to the electric charge of the ionic component of the coatings (9, 9a, 9b, 9c, 9d) in step (b) and/or to have the same electric charge as the ionic component of the coatings (9, 9a, 9b, 9c, 9d) in step (c), and
wherein a print object electrode (5) is provided on another side of the print object (4) that is opposite to a side of the print object (4) on which a pattern is formed, and is electrified to have the electric charge opposite to the electric charge of the ionic component of the coatings (9, 9a, 9b, 9c, 9d) in step (c),
**characterized in that**
the electrode (6) on the first substrate (8) is electrified to have the same electric charge as the ionic component of the coatings (9, 9a, 9b, 9c, 9d) in step (b).

2. A method of forming a pattern of coatings (9, 9a, 9b, 9c, 9d), the method comprising the steps of:
a) filling the coatings (9, 9a, 9b, 9c, 9d) containing an ionic component having a positive or negative electric charge in a groove of a first side (8a) of a first substrate (8);
b) bringing a first side (2a) of a second substrate (2) into contact with the first side (8a) of the first substrate (8) to transfer the coatings (9, 9a, 9b, 9c, 9d) filled in the groove of the first substrate (8) onto the second substrate (2); and
c) bringing the first side (2a) of the second substrate (2) into contact with a print object (4) to transfer the coatings (9, 9a, 9b, 9c, 9d) from the second substrate (2) onto the print object (4),
wherein an electrode (6, 1) is provided on a second side (8b, 2b), of the first substrate (8) and the second substrate (2), which is opposite to the first side (8a, 2a) of the substrate (8, 2),
wherein the electrode (1) on the second substrate (2) is electrified to have the electric charge opposite to the electric charge of the ionic component of the coatings (9, 9a, 9b, 9c, 9d) in step (b) and/or to have the same electric charge as the ionic component of the coatings (9, 9a, 9b, 9c, 9d) in step (c),
wherein a print object electrode (5) is provided on another side of the print object (4) that is opposite to a side of the print object (4) on which a pattern is formed, and is electrified to have the electric charge opposite to the electric charge of the ionic component of the coatings (9, 9a, 9b, 9c, 9d) in step (c),
**characterized in that**
the electrode (6) on the first substrate (8) is electrified to have the same electric charge as the ionic component of the coatings (9, 9a, 9b, 9c, 9d) in step (b).

3. The method according to claim 1 or 2,
wherein the first substrate (8) is formed of any one of a silicon rubber material, a hard plastic material, and a glass material.

4. The method according to claim 1 or 2,
wherein a surface of the first substrate (8) is reformed before step (a), by any one of surface coating processes of coating the surface of the first substrate (8) using a hydrophobic material and process of hydrophobic surface treatment of the surface of the first substrate (8) using plasma.

5. The method according to claim 1 or 2,
wherein the second substrate (2) is formed of any one of metal, a hard plastic material, and a silicon compound.

6. The method according to claim 1,
wherein at least one of the first substrate electrode (6) on the first substrate (8) and the second substrate electrode (1) on the second substrate (2) has the corresponding shape to the uneven portion of the first side (2a) of the second substrate (2).

7. The method according to claim 1 or 2,
wherein the print object (4) is formed of any one of a glass material, a flexible plastic material, and a hard plastic material.

8. The method according to claim 1,
wherein a print object electrode (5) is provided on another side of the print object (4) that is opposite to a side of the print object (4) on which a pattern is formed, and has the corresponding shape to the uneven portion of the first side (2a) of the second substrate (2).

9. The method according to claim 1 or 2,
wherein at least one of the first substrate (8) and the second substrate (2) has a flat plate or roll shape.

10. The method according to claim 1 or 2,
wherein the first substrate (8) and the second substrate (2) are fixed to first sides of a first substrate support (7) and a second substrate support (13), and the first substrate electrode (6) on the first substrate (8) and the second substrate electrode (1) on the second substrate (2) are provided on second sides of the first substrate support (7) and the second substrate support (13) that are opposite to the first sides of the first substrate support (7) and the second substrate support (13).

11. The method according to claim 10
wherein the first substrate (8) and the second substrate (2) are fixed to the first substrate support (7) and the second substrate support (13) in vacuum.

12. The method according to claim 1 or 2,
wherein the contact in step (b) or the contact in step (c) is controlled using an electrical and optical compression sensing process to apply uniform pressure to an entire contact surface.

13. The method according to claim 12,
wherein the electrical and optical compression sensing process is performed using a piezodielectric sensor or a laser interferometer.

14. The method according to claim 1, further comprising the steps of:
d) bringing the coatings (9, 9a, 9b, 9c, 9d) remaining on the first substrate (8) or the second substrate (2) into contact with a first side of a cleaning substrate (11) to remove the coatings (9, 9a, 9b, 9c, 9d) from the first substrate (8) or the second substrate (2).

15. The method according to claim 14,
wherein a cleaning substrate electrode (10) is provided on a second side of the cleaning substrate (11) that is opposite to the first side of the cleaning substrate (11), and is electrified to have the electric charge opposite to the electric charge of the ionic component of the coatings (9, 9a, 9b, 9c, 9d) remaining on the first substrate (8) or the second substrate (2).

16. The method according to claim 14,
wherein the cleaning substrate (11) is formed of any one of an inorganic material, a hard plastic material, and glass.

17. The method according to claim 1 or 2,
wherein the coatings (9, 9a, 9b, 9c, 9d) of the step (a) is a composition comprising 50 to 95 wt. % of an electronic material; and 5 to 50 wt. % of a cationic or anionic component,
wherein the electronic material is selected from the group consisting of an optical ink, a metal solution for wires, a conductive paste, a resist, an adhesive, and a glue,
wherein the cationic component or the anionic component is one or more selected from the group consisting of a polymer that is polymerized using monovalent or divalent cationic or anionic monomers; a binder polymer selected from the group consisting of a copolymer that is polymerized using nonionic monomers and monovalent or divalent anionic or cationic monomers, and a derivative thereof; an organic or inorganic surfactant containing monovalent or divalent cationic or anionic components; and a monovalent or divalent cationic or anionic dye, a monovalent or divalent cationic or anionic pigment, and a complex thereof.

18. The method according to claim 1,
wherein the pattern formed with the coating is used in an electronic device.

19. The method according to claim 18,
wherein the electronic device is comprised in an electronic apparatus.

20. An apparatus for forming a pattern comprising:
a first substrate (8);
a coater (3) provided so that the coater (3) is capable of being moved along a first side (8a) of the first substrate (8) by a coater movement device to coat the first side (8a) of the first substrate (8) using coatings (9, 9a, 9b, 9c, 9d) containing an ionic component having a positive or negative electric charge;
a second substrate (2) provided so that the second substrate (2) is capable of being moved in z-, x-, y-, and θ-axis directions based on a surface of the substrate (2) by a substrate movement device to come into contact with the first side (8a) of the first substrate (8) and having projections (2c), which is formed on a first side (2a) of the second substrate (2), to which the coatings (9, 9a, 9b, 9c, 9d) applied on the first side (8a) of the first substrate (8) is transferred using the coater (3); and
an electrode (6, 1) provided on the first substrate (8) and the second substrate (2),
wherein the first side (2a) of the second substrate (2) comes into contact with a print object (4) to transfer the coatings (9, 9a, 9b, 9c, 9d) onto the print object (4), thereby forming the pattern on the print object (4), and
wherein the electrode (6, 1) includes a first substrate electrode (6) provided on the second side (8b) of the first substrate (8) and a second substrate electrode (1) provided on a second side (2b) of the second substrate (2),
the second substrate (2) is moved so that projections (2c) formed on the first side (2a) of the second substrate (2) come into contact with the coatings (9, 9a, 9b, 9c, 9d) applied on the first side (8a) of the first substrate (8) using the coater (3),
wherein the second substrate electrode (1) is electrified to have the electric charge opposite to the electric charge of the ionic component of the coatings (9, 9a, 9b, 9c, 9d) applied on the first side (8a) of the first substrate (8), thereby transferring the coatings (9, 9a, 9b, 9c, 9d) which are applied on the first side (8a) of the first substrate (8) onto the projections (2c) formed on the first side (2a) of the second substrate (2), and
the second substrate electrode (1) is electrified to have the same electric charge as the ionic component of the coatings (9, 9a, 9b, 9c, 9d) attached to the projections (2c) of the second substrate (2) so that the coatings (9, 9a, 9b, 9c, 9d) attached to the projections (2c) of the second substrate (2) is transferred onto the print object (4), thereby forming the pattern on the print object (4),
**characterized in that** the first substrate electrode (6) is electrified to have the same electric charge as the ionic component of the coatings (9, 9a, 9b, 9c, 9d) applied on the first side (8a) of the first substrate (8).

21. The apparatus according to claim 20 , further comprising:
a print object electrode (5) provided on the print object (4),
wherein the print object electrode (5) is electrified to have the electric charge opposite to the electric charge of the ionic component of the coatings (9, 9a, 9b, 9c, 9d) attached to the projections (2c) of the second substrate (2) when the first side (2a) of the second substrate (2) comes into contact with the print object (4).

22. The apparatus according to claim 20 wherein the substrate movement apparatus includes:
a first movement device that includes a movement support frame (32) for guiding movement of the second substrate (2), and a first control screw (31) provided in the movement support frame (32) to control the movement of the second substrate (2) in a z-axis direction with respect to a surface of the second substrate (2); and
a second movement device that includes a second control screw (33) and a third control screw (34) provided in the second substrate (2) to control the movement of the second substrate (2) in x-axis, y-axis, and θ-taxis directions along surface direction of the second substrate (2).

23. The apparatus according to claim 22,
wherein the substrate movement device further comprises a stepping motor (35) that is connected to at least one of the first control screw (31), the second control screw (33), and the third control screw (34).

24. The apparatus according to claim 20 , wherein the coater movement
device comprises:
a coater mounting frame (40) on which the coater (3) is mounted; and
a linear motor (41) that moves the coater mounting frame (40) on which the coater (3) is mounted right and left.

25. The apparatus according to claim 20 , further comprising:
a support fixing frame (20) that supports the first substrate (8) and the print object (4) from below.

26. The apparatus according to claim 20 , further comprising:
a cleaning substrate (11) provided so as to be capable of coming close to the first substrate (8) and be separated from the first substrate (8) when the coatings (9, 9a, 9b, 9c, 9d) attached to the projections (2c) of the second substrate (2) is transferred onto the print object (4), thereby removing the coatings (9, 9a, 9b, 9c, 9d) remaining on the first side (8a) of the first substrate (8).

27. An apparatus for forming a pattern comprising:
a first substrate (8) having a first side (8a) on which a groove where coatings (9, 9a, 9b, 9c, 9d) containing an ionic component having a positive or negative electric charge are filled is formed;
a second substrate (2) provided so that the second substrate (2) is capable of being moved in z-, x-, y-, and θ-axis directions based on a surface of the substrate (2) by a substrate movement device to come into contact with the first side (8a) of the first substrate (8), the second substrate (2) having a first side (2a) onto which the coatings (9, 9a, 9b, 9c, 9d) filled in the groove of the first substrate (8) are transferred; and
an electrode (6, 1) provided on the first substrate (8) and the second substrate (2),
wherein the coatings (9, 9a, 9b, 9c, 9d) filled in the groove of the first substrate (8) are transferred onto the first side (2a) of the second substrate (2), and the first side (2a) of the second substrate (2) comes into contact with the print object (4) to transfer the coatings (9, 9a, 9b, 9c, 9d) onto the print object (4), thereby forming the pattern on the print object (4),
wherein the electrode (6, 1) includes a first substrate electrode (6) provided on a second side (8b) of the first substrate (8), and a second substrate electrode (1) provided on a second side (2b) of the second substrate (2),
the second substrate is moved so that the first side (2a) of the second substrate (2) comes into contact with the coatings (9, 9a, 9b, 9c, 9d) filled in the groove formed on the first side (8a) of the first substrate (8),
the second substrate electrode (1) is electrified to have the electric charge opposite to the electric charge of the ionic component of the coatings (9, 9a, 9b, 9c, 9d) filled in the groove formed on the first side (8a) of the first substrate (8), thereby transferring the coatings (9, 9a, 9b, 9c, 9d) which are filled in the groove formed on the first side (8a) of the first substrate (8) onto the first side (2a) of the second substrate (2), and
the second substrate electrode (1) is electrified to have the same electric charge as the ionic component of the coatings (9, 9a, 9b, 9c, 9d) attached to the first side (2a) of the second substrate (2) so that the coatings (9, 9a, 9b, 9c, 9d) attached to the first side (2a) of the second substrate (2) is transferred onto the print object (4), thereby forming the pattern on the print object (4),
**characterized in that**
the first substrate electrode (6) is electrified to have the same electric charge as the ionic component of the coatings (9, 9a, 9b, 9c, 9d) filled in the groove formed on the first side of the first substrate (8).

28. The apparatus according to claim 27, further comprising:
a print object electrode (5) provided on the print object (4),
wherein the print object electrode (5) is electrified to have the electric charge opposite to the electric charge of the ionic component of the coatings (9, 9a, 9b, 9c, 9d) attached to the first side (2a) of the second substrate (2) when the first side (2a) of the second substrate (2) comes into contact with the print object (4).

29. The apparatus according to claim 27, wherein the substrate movement
device includes:
a first movement device that includes a movement support frame (32) for guiding movement of the second substrate (2), and a first control screw (31) provided in the movement support frame (32) to control the movement of the second substrate (2) in a z-axis direction with respect to a surface of the second substrate (2); and
a second movement device that includes a second control screw (33) and a third control screw (34) provided in the second substrate (2) to control the movement of the second substrate (2) in x-axis, y-axis, and θ-axis directions along surface direction of the second substrate (2).

30. The apparatus according to claim 29,
wherein the substrate movement device further comprises a stepping motor (35) that is connected to at least one of the first control screw (31), the second control screw (33), and the third control screw (34).

31. The apparatus according to claim 27, further comprising:
a support fixing frame (20) that supports the first substrate (8) and the print object (4) from below.

32. An apparatus for forming a pattern comprising:
a first substrate (8) that is rotatably provided and has a roll shape;
a coater (3) that coats a surface of the first substrate (8) using coatings (9, 9a, 9b, 9c, 9d) containing an ionic component having a positive or negative electric charge;
a second substrate (2) having a first side (2a), with projections (2c) to which the coatings (9, 9a, 9b, 9c, 9d) applied on the first substrate (8) are transferred using the coater (3); and
an electrode (6, 1) provided on the first substrate (8) and the second substrate (2),
wherein the first substrate (8) is rotated while being in contact with the first side (2a) of the second substrate (2) to transfer the coatings (9, 9a, 9b, 9c, 9d) applied on the surface of the first substrate (8) onto the projections (2c) formed on the first side (2a) of the second substrate (2), and the coatings (9, 9a, 9b, 9c, 9d) attached to the projections (2c) of the second substrate (2) comes into contact with the print object (4) to transfer the coatings (9, 9a, 9b, 9c, 9d) onto the print object (4), thereby forming the pattern on the print object (4), and
wherein the electrode (6, 1) includes a first substrate electrode (6) provided on the first substrate (8), and a second substrate electrode (1) provided on the second substrate (2),
the coatings (9, 9a, 9b, 9c, 9d) are applied, on a surface of the first substrate (8) using the coater (3), along the surface of the first substrate (8) while the first substrate (8) is rotated,
the second substrate electrode (1) is electrified to have the electric charge opposite to the electric charge of the ionic component of the coatings (9, 9a, 9b, 9c, 9d) formed on the surface of the first substrate (8), and the first substrate (8) on which the coatings (9, 9a, 9b, 9c, 9d) are applied is rotated while the first substrate (8) is in contact with the first side (2a) of the second substrate (2) so that the first substrate (8) is moved along the surface of the first side (2a) of the second substrate (2), thereby transferring the coatings (3) from the first substrate (8) onto the projections (2c) the second substrate (2), and
the second substrate electrode (1) is electrified to have the same electric charge as the ionic component of the coatings (9, 9a, 9b, 9c, 9d) attached to the projections (2c) of the second substrate (2) so that the coatings (9, 9a, 9b, 9c, 9d) attached to the projections (2c) of the second substrate (2) is transferred onto the print object (4), thereby forming the pattern on the print object (4),
**characterized in that**
the first substrate electrode (6) is electrified to have the same electric charge as the ionic component of the coatings (9, 9a, 9b, 9c, 9d) applied on the surface of the first substrate (8).

33. The apparatus according to claim 32, further comprising:
a print object electrode (5) provided on the print object (4),
wherein the print object electrode (5) is electrified to have the electric charge opposite to the electric charge of the ionic component of the coatings (9, 9a, 9b, 9c, 9d) attached to the projections (2c) of the second substrate (2) when the second substrate (2) comes into contact with the print object (4).

## Patentansprüche

1. Verfahren zum Ausbilden eines Musters, wobei das Verfahren die folgenden Schritte umfasst:
a) Aufbringen von Beschichtung (9, 9a, 9b, 9c, 9d), die eine Ionenkomponente mit einer positiven oder negativen elektrischen Ladung umfasst, auf einer ersten Seite (8a) eines ersten Substrats (8);
b) in Kontakt Bringen der ersten Seite (8a) des ersten Substrats (8) mit einem unebenen Abschnitt einer ersten Seite (2a) eines zweiten Substrats (2), um einen Teil der Beschichtung (9, 9a, 9b, 9c, 9d), der Vorsprüngen (2c) des zweiten Substrats (2) entspricht, von dem ersten Substrat (8) auf das zweite Substrat (2) zu transferieren; und
c) in Kontakt Bringen der ersten Seite (2a) des zweiten Substrats (2) mit einem Druckobjekt (4), um die Beschichtung (9, 9a, 9b, 9c, 9d) auf das Druckobjekt (4) zu übertragen,
wobei eine Elektrode (6, 1) auf einer zweiten Seite (8b, 2b) des ersten Substrats (8) und des zweiten Substrats (2) vorgesehen ist, die der ersten Seite (8a, 2a) des Substrats (8, 2) gegenüberliegt,
wobei die Elektrode (1) auf dem zweiten Substrat (2) so elektrifiziert ist, dass sie eine elektrische Ladung entgegengesetzt der elektrischen Ladung der Ionenkomponente der Beschichtung (9, 9a, 9b, 9c, 9d) in Schritt (b) hat und/oder dieselbe elektrische Ladung wie die Ionenkomponente der Beschichtung (9, 9a, 9b, 9c, 9d) in Schritt (c) hat, und
wobei eine Druckobjektelektrode (5) auf einer anderen Seite des Druckobjekts (4), die einer Seite des Druckobjekts (4) gegenüberliegt, auf der ein Muster ausgebildet ist, vorgesehen ist und so elektrifiziert ist, dass sie eine elektrische Ladung entgegengesetzt der elektrischen Ladung der Ionenkomponente der Beschichtung (9, 9a, 9b, 9c, 9d) in Schritt (c) hat,
**dadurch gekennzeichnet, dass**
die Elektrode (6) an dem ersten Substrat (8) so elektrifiziert ist, dass sie dieselbe elektrische Ladung wie die Ionenkomponente der Beschichtung (9, 9a, 9b, 9c, 9d) in Schritt (b) hat.

2. Verfahren zum Ausbilden eines Musters von Beschichtung (9, 9a, 9b, 9c, 9d), wobei das Verfahren die folgenden Schritte umfasst:
a) Füllen der Beschichtung (9, 9a, 9b, 9c, 9d), die eine Ionenkomponente mit einer positiven oder negativen elektrischen Ladung enthält, in eine Nut einer ersten Seite (8a) eines ersten Substrats (8);
b) in Kontakt Bringen einer ersten Seite (2a) eines zweiten Substrats (2) mit der ersten Seite (8a) des ersten Substrats (8), um die Beschichtung (9, 9a, 9b, 9c, 9d), die in die Nut des ersten Substrats (8) gefüllt ist, auf das zweite Substrat (2) zu übertragen; und
c) in Kontakt Bringen der ersten Seite (2a) des zweiten Substrats (2) mit einem Druckobjekt (4), um die Beschichtung (9, 9a, 9b, 9c, 9d) von dem zweiten Substrat (2) auf das Druckobjekt (4) zu übertragen,
wobei eine Elektrode (6, 1) auf einer zweiten Seite (8b, 2b) des ersten Substrats (8) und des zweiten Substrats (2), die der ersten Seite (8a, 2a) des Substrats (8, 2) gegenüberliegt, vorgesehen ist,
wobei eine Elektrode (1) auf dem zweiten Substrat (2) so elektrifiziert ist, dass sie eine elektrische Ladung entgegengesetzt zu der elektrischen Ladung der Ionenkomponente der Beschichtung (9, 9a, 9b, 9c, 9d) in Schritt (b) und/oder dieselbe elektrische Ladung wie die Ionenkomponente der Beschichtung (9, 9a, 9b, 9c, 9d) in Schritt (c) hat,
wobei eine Druckobjektelektrode (5) auf einer anderen Seite des Druckobjekts (4), die einer Seite des Druckobjekts (4), auf der ein Muster ausgebildet ist, gegenüberliegt, vorgesehen und so elektrifiziert ist, dass sie die elektrische Ladung entgegengesetzt der elektrischen Ladung der Ionenkomponente der Beschichtung (9, 9a, 9b, 9c, 9d) in Schritt (c) hat,
**dadurch gekennzeichnet, dass**
die Elektrode (6) auf dem ersten Substrat (8) so elektrifiziert ist, dass sie dieselbe elektrische Ladung wie die Ionenkomponente der Beschichtung (9, 9a, 9b, 9c, 9d) in Schritt (b) hat.

3. Verfahren nach Anspruch 1 oder 2, wobei das erste Substrat (8) aus einem Silizium-Gummimaterial, Hartkunststoffmaterial oder Glasmaterial ausgebildet ist.

4. Verfahren nach Anspruch 1 oder 2,
wobei eine Oberfläche des ersten Substrats (8) vor dem Schritt (a) durch einen Oberflächenbeschichtungsprozess des Beschichtens der Oberfläche des ersten Substrats (8) unter Verwendung eines hydrophoben Materials oder einen Prozess einer hydrophoben Oberflächenbehandlung der Oberfläche des ersten Substrats (8) unter Verwendung von Plasma wieder ausgebildet wird.

5. Verfahren nach Anspruch 1 oder 2, wobei das zweite Substrat (2) aus Metall, einem Hartkunststoff oder einem Siliziumverbund ausgebildet ist.

6. Verfahren nach Anspruch 1, wobei die erste Substratelektrode (6) auf dem ersten Substrat (8) und/oder die zweite Substratelektrode (1) auf dem zweiten Substrat (2) die dem unebenen Abschnitt der ersten Seite (2h) des zweiten Substrats (2) entsprechende Form aufweist.

7. Verfahren nach Anspruch 1 oder 2, wobei das Druckobjekt (4) aus einem Glasmaterial, einem flexiblen Kunststoffmaterial oder einem Hartkunststoffmaterial ausgebildet ist.

8. Verfahren nach Anspruch 1, wobei eine Druckobjektelektrode (5) auf einer anderen Seite des Druckobjekts (4), die einer Seite des Druckobjekts (4), auf der ein Muster ausgebildet ist, gegenüberliegt, vorgesehen ist und die dem unebenen Abschnitt der ersten Seite (2a) des zweiten Substrats (2) entsprechende Form aufweist.

9. Verfahren nach Anspruch 1 oder 2, wobei das erste Substrat (8) und/oder das zweite Substrat (2) eine flache Plattenform oder Rollenform hat.

10. Verfahren nach Anspruch 1 oder 2, wobei das erste Substrat (8) und das zweite Substrat (2) an ersten Seiten einer ersten Substratstütze (7) und einer zweiten Substratstütze (13) befestigt sind und die erste Substratelektrode (6) an dem ersten Substrat (8) und die zweite Substratelektrode (1) an dem zweiten Substrat (2) auf zweiten Seiten der ersten Substratstütze (7) und der zweiten Substratstütze (13), die den ersten Seiten der ersten Substratstütze (7) und der zweiten Substratstütze (13) gegenüberliegen, vorgesehen sind.

11. Verfahren nach Anspruch 10, wobei das erste Substrat (8) und das zweite Substrat (2) an der ersten Substratstütze (7) und der zweiten Substratstütze (13) im Vakuum befestigt sind.

12. Verfahren nach Anspruch 1 oder 2, wobei der Kontakt im Schritt (b) oder der Kontakt im Schritt (c) unter Verwendung eines elektrischen und optischen Kompressiönsmessverfahrens gesteuert wird, um einen gleichmäßigen Druck über eine gesamte Kontaktoberfläche aufzubringen.

13. Verfahren nach Anspruch 12, wobei das elektrische und optische Kompressionsmessverfahren unter Verwendung eines piezoelektrischen Sensors oder eines Laserinterferometers durchgeführt wird.

14. Verfahren nach Anspruch 1, ferner umfassend den Schritt des:
d) in Kontakt Bringens der Beschichtung (9, 9a, 9b, 9c, 9d), die auf dem ersten Substrat (8) oder dem zweiten Substrat (2) verblieben ist, mit einer ersten Seite einer Reinigungsoberfläche (11), um die Beschichtung (9, 9a, 9b, 9c, 9d) von dem ersten Substrat (8) oder dem zweiten Substrat (2) zu entfernen.

15. Verfahren nach Anspruch 14, wobei eine Reinigungssubstratelektrode (10) an einer zweiten Seite des Reinigungssubstrats (11), die der ersten Seite des Reinigungssubstrats (11) gegenüberliegt, vorgesehen ist und so elektrifiziert ist, dass sie die elektrische Ladung entgegengesetzt der elektrischen Ladung der Ionenkomponente der Beschichtung (9, 9a, 9b, 9c, 9d), die auf dem ersten Substrat (8) oder dem zweiten Substrat (2) verblieben ist, hat.

16. Verfahren nach Anspruch 14, wobei das Reinigungssubstrat (11) aus einem anorganischen Material, einem Hartkunststoffmaterial oder Glas ausgebildet ist.

17. Verfahren nach Anspruch 1 oder 2, wobei die Beschichtung (9, 9a, 9b, 9c, 9d) des Schrittes (a) eine Mischung umfassend 50-95 Gew.-% eines elektronischen Materials und 5-50 Gew.-% einer kationischen oder anionischen Komponente ist,
wobei das elektronische Material aus der Gruppe ausgewählt ist, die aus einer optischen Tinte, einer Metalllösung für Drähte, einer leitenden Paste, eines Widerstands, eines Klebstoffs und eines Leims besteht,
wobei die kationische Komponente oder die anionische Komponente eine oder mehrere aus der Gruppe ausgewählte ist, die aus einem Polymer, das unter Verwendung monovalenter oder bivalenter kationischer oder anionischer Monomere polymerisiert ist; einem Bindepolymer, das aus der Gruppe ausgewählt ist, die aus einem Copolymer besteht, das unter Verwendung nicht-ionischer Monomere und monovalenter oder bivalenter anionischer oder kationischer Monomere und einem Derivat hiervon polemisiert ist; einem organischen oder anorganischen Tensid, das monovalente oder bivalente kationische oder anionische Komponenten umfasst; und einem monovalenten oder bivalenten kationischen oder anionischen Farbstoff, einem monovalenten oder bivalenten kationischen oder anionischen Pigment und einem Komplex hiervon besteht.

18. Verfahren nach Anspruch 1, wobei das Muster, das mit der Beschichtung ausgebildet wird, als eine elektronische Vorrichtung verwendet wird.

19. Verfahren nach Anspruch 18, wobei die elektronische Vorrichtung in einer elektronischen Apparatur enthalten ist.

20. Vorrichtung zum Bilden eines Musters umfassend:
ein erstes Substrat (8);
einen Beschichter (3), der so vorgesehen ist, dass der Beschichter (3) dazu geeignet ist, entlang einer ersten Seite (8a) des ersten Substrats (8) durch eine Beschichter-Bewegungsvorrichtung bewegt zu werden, um die erste Seite (8a) des ersten Substrats (8) unter Verwendung einer Beschichtung (9, 9a, 9b, 9c, 9d), die eine Ionenkomponente mit einer positiven oder negativen elektrischen Ladung umfasst, zu beschichteten;
ein zweites Substrat (2), das so vorgesehen ist, dass das zweite Substrat (2) dazu geeignet ist, in der Z-, X-, Y- und θ-Achsenrichtung basierend auf einer Oberfläche des Substrats (2) durch eine Substratbewegungsvorrichtung bewegt zu werden, um in Kontakt mit der ersten Seite (8a) des ersten Substrats (8) zu kommen, und das Vorsprünge (2c) aufweist, die auf einer ersten Seite (2a) des zweiten Substrats (2) ausgebildet sind, auf welche die Beschichtung (9, 9a, 9b, 9c, 9d), die auf die erste Seite (8a) des ersten Substrats (8) aufgebracht wurde, unter Verwendung des Beschichters (3) übertragen wird; und
eine Elektrode (6, 1), die auf dem ersten Substrat (8) und dem zweiten Substrat (2) vorgesehen ist,
wobei die erste Seite (2a) des zweiten Substrats (2) in Kontakt mit einem Druckobjekt (4) kommt, um die Beschichtung (9, 9a, 9b, 9c, 9d) auf das Druckobjekt (4) zu übertragen, wodurch das Muster auf dem Druckobjekt (4) ausgebildet wird, und
wobei die Elektrode (6, 1) eine erste Substratelektrode (6), die auf der zweiten Seite (8b) des ersten Substrats (8) vorgesehen ist, und eine zweite Substratelektrode (1), die auf einer zweiten Seite (2b) des zweiten Substrats (2) vorgesehen ist, umfasst,
wobei das zweite Substrat (2) so bewegt wird, dass Vorsprünge (2c), die auf der ersten Seite (2a) des zweiten Substrats (2) ausgebildet sind, in Kontakt mit der Beschichtung (9, 9a, 9b, 9c, 9d) kommen, die auf die erste Seite (8a) des ersten Substrats (8) unter Verwendung des Beschichters (3) aufgebracht ist,
wobei die zweite Substratelektröde (1) so elektrifiziert ist, dass sie die elektrische Ladung entgegengesetzt der elektrischen Ladung der Ionenkomponente der Beschichtung (9, 9a, 9b, 9c, 9d), die auf die erste Seite (8a) des ersten Substrats (8) aufgebracht wurde, hat, wodurch die Beschichtung (9, 9a, 9b, 9c, 9d), die auf die erste Seite (8a) des ersten Substrats (8) aufgebracht wurde, auf die Vorsprünge (2c), die auf der ersten Seite (2a) des zweiten Substrats (2) ausgebildet sind, übertragen wird, und
die zweite Substratelektrode (1) so elektrifiziert ist, dass sie dieselbe elektrische Ladung wie die Ionenkomponente der Beschichtung (9, 9a, 9b, 9c, 9d), die an den Vorsprüngen (2c) des zweiten Substrats (2) angebracht ist, hat, sodass die Beschichtung (9, 9a, 9b, 9c, 9d), die an den Vorsprüngen (2c) des zweiten Substrats (2) angebracht ist, auf das Druckobjekt (4) übertragen wird, wodurch das Muster auf dem Druckobjekt (4) ausgebildet wird,
**dadurch gekennzeichnet, dass** die erste Substratelektrode (6) so elektrifiziert ist, dass sie dieselbe elektrische Ladung wie die Ionenkomponente der Beschichtung (9, 9a, 9b, 9c, 9d), die auf die erste Seite (8a) des ersten Substrats (8) aufgebracht ist, hat.

21. Vorrichtung nach Anspruch 20, ferner umfassend:
eine Druckobjektelektrode (5), die auf dem Druckobjekt (4) ausgebildet ist,
wobei die Druckobjektelektrode (5) so elektrifiziert ist, dass sie die elektrische Ladung entgegengesetzt der elektrischen Ladung der Ionenkomponente der Beschichtung (9, 9a, 9b, 9c, 9d), die an den Vorsprüngen (2c) des zweiten Substrats (2) angebracht ist, hat, wenn die erste Seite (2a) des zweiten Substrats (2) in Kontakt mit dem Druckobjekt (4) kommt.

22. Vorrichtung nach Anspruch 20, wobei die Substratbewegungsvorrichtung umfasst:
eine erste Bewegungsvorrichtung, die einen Bewegungsstützrahmen (32) zum Führen einer Bewegung des zweiten Substrats (2) und eine erste Steuerungsschraube (31), die in dem Bewegungsstützrahmen vorgesehen ist, um die Bewegung des zweiten Substrats (2) in einer Zeitachsenrichtung in Bezug auf eine Oberfläche des zweiten Substrats (2) zu steuern, umfasst; und
eine zweite Bewegungsvorrichtung, die eine zweite Steuerungsschraube (33) und eine dritte Steuerungsschraube (34) umfasst, die in dem zweiten Substrat (2) vorgesehen sind, um die Bewegung des zweiten Substrats (2) in den Richtungen der X-Achse, Y-Achse und θ-Achse entlang der Oberflächenrichtung des zweiten Substrats (2) zu steuern.

23. Vorrichtung nach Anspruch 22, wobei die Substratbewegungsvorrichtung ferner einen Schrittmotor (35) aufweist, der mit zumindest einer der ersten Steuerungsschraube (31), der zweiten Steuerungsschraube (33) und der dritten Steuerungsschraube (34) verbunden ist.

24. Vorrichtung nach Anspruch 20, wobei die Beschichter-Bewegungsvorrichtung umfasst:
einen Beschichter-Montagerahmen (40), an dem der Beschichter (3) montiert ist; und
einen Linearmotor (41), der den Beschichter-Montagerahmen (40) nach rechts und links bewegt, an dem der Beschichter (3) montiert ist.

25. Vorrichtung nach Anspruch 20, ferner umfassend:
einen Stütz-Befestigungsrahmen (20), der das erste Substrat (8) und das Druckobjekt (4) von unten stützt.

26. Vorrichtung nach Anspruch 20, ferner umfassend:
ein Reinigungssubstrat (11), das dazu vorgesehen ist, um dazu in der Lage zu sein, nah an das erste Substrat (8) heran zu gelangen und von dem ersten Substrat (8) getrennt zu werden, wenn die Beschichtung (9, 9a, 9b, 9c, 9d), die an den Vorsprüngen (2c) des zweiten Substrats (2) angebracht ist, auf das Druckobjekt (4) übertragen wird, wodurch die Beschichtung (9, 9a, 9b, 9c, 9d), die an der ersten Seite (8a) des ersten Substrats (8) verblieben ist, entfernt wird.

27. Vorrichtung zum Ausbilden eines Musters umfassend:
ein erstes Substrat (8) mit einer ersten Seite (8a), an der eine Nut ausgebildet ist, wo eine Beschichtung (9, 9a, 9b, 9c, 9d) mit einer Ionenkomponente mit einer positiven oder negativen elektrischen Ladung eingefüllt ist;
ein zweite Substrat (2), das so vorgesehen ist, dass das zweite Substrat (2) dazu in der Lage ist, in Z-, X-, Y-und θ-Richtung bewegt zu werden, basierend auf einer Oberfläche des Substrats (2) durch eine Substratbewegungsvorrichtung, um in Kontakt mit der ersten Seite (8a) des ersten Substrats (8) zu gelangen, wobei das zweite Substrat (2) eine erste Seite (2a) aufweist, auf die die Beschichtung (9, 9a, 9b, 9c, 9d), die in die Nut des ersten Substrats (8) gefüllt ist, übertragen wird; und
eine Elektrode (6, 1), die auf dem ersten Substrat (8) und dem zweiten Substrat (2) vorgesehen ist,
wobei die Beschichtung (9, 9a, 9b, 9c, 9d), die in die Nut des ersten Substrats (8) gefüllt ist, auf die erste Seite (2a) des zweiten Substrats (2) übertragen wird, und die erste Seite (2a) des zweiten Substrats (2) in Kontakt mit dem Druckobjekt (4) gelangt, um die Beschichtung (9, 9a, 9b, 9c, 9d) auf das Druckobjekt (4) zu übertragen, wodurch das Muster auf dem Druckobjekt (4) ausgebildet wird,
wobei die Elektrode (6, 1) eine erste Substratelektrode (6), die an einer zweiten Seite (8b) des ersten Substrats (8) vorgesehen ist, und eine zweite Substratelektrode (1), die an einer zweiten Seite (2b) des zweiten Substrats (2) vorgesehen ist, umfasst,
wobei das zweite Substrat so bewegt wird, dass die erste Seite (2a) des zweiten Substrats (2) in Kontakt mit der Beschichtung (9, 9a, 9b, 9c, 9d) gelangt, die in die Nut gefüllt ist, die auf der ersten Seite (8a) des ersten Substrats (8) ausgebildet ist,
die zweite Substratelektrode (1) so elektrifiziert ist, dass sie die elektrische Ladung entgegengesetzt der elektrischen Ladung der Ionenkomponente der Beschichtung (9, 9a, 9b, 9c, 9d) hat, die in die Nut gefüllt ist, die an der ersten Seite (8a) des ersten Substrats (8) ausgebildet ist, wodurch die Beschichtung (9, 9a, 9b, 9c, 9d), die in die Nut gefüllt ist, die auf der ersten Seite (8a) des ersten Substrats (8) ausgebildet ist, auf die erste Seite (2a) des zweiten Substrats (2) übertragen wird, und
die zweite Substratelektrode (1) so elektrifiziert ist, dass sie dieselbe elektrische Ladung wie die Ionenkomponente der Beschichtung (9, 9a, 9b, 9c, 9d) hat, die an der ersten Seite (2a) des ersten Substrats (2) angebracht ist, so dass die Beschichtung (9, 9a, 9b, 9c, 9d), die an der ersten Seite (2a) des zweiten Substrats (2) angebracht ist, auf das Druckobjekt (4) übertragen wird, wodurch das Muster auf dem Druckobjekt (4) ausgebildet wird,
**dadurch gekennzeichnet, dass**
die erste Substratelektrode (6) so elektrifiziert ist, dass sie dieselbe elektrische Ladung wie die Ionenkomponente der Beschichtung (9, 9a, 9b, 9c, 9d) hat, die in die Nut gefüllt ist, die auf der ersten Seite des ersten Substrats (8) ausgebildet ist.

28. Vorrichtung nach Anspruch 27, ferner umfassend:
eine Druckobjektelektrode (5), die auf dem Druckobjekt (4) vorgesehen ist,
wobei die Druckobjektelektrode (5) so elektrifiziert ist, dass sie die elektrische Ladung entgegengesetzt der elektrischen Ladung der Ionenkomponente der Beschichtung (9, 9a, 9b, 9c, 9d) hat, die an der ersten Seite (2a) des zweiten Substrats (2) angebracht ist, wenn die erste Seite (2a) des zweiten Substrats (2) in Kontakt mit dem Druckobjekt (4) kommt.

29. Vorrichtung nach Anspruch 27, wobei die Substratbewegungsvorrichtung umfasst:
eine erste Bewegungsvorrichtung, die einen Bewegungsstützrahmen (32) zum Führen einer Bewegung des zweiten Substrats (2) und eine erste Steuerungsschraube (31), die in dem Bewegungsstützrahmen (32) vorgesehen ist, um die Bewegung des zweiten Substrats (2) in Richtung einer Z-Achse in Bezug auf eine Oberfläche des zweiten Substrats (2) zu steuern, umfasst; und
eine zweite Bewegungsvorrichtung, die eine zweite Steuerungsschraube (33) und eine dritte Steuerungsschraube (34), die in dem zweiten Substrat (2) vorgesehen sind, um die Bewegung des zweiten Substrats (2) in Richtung der X-Achse, Y-Achse und θ-Achse entlang einer Oberflächenrichtung des zweiten Substrats (2) zu steuern, umfasst.

30. Vorrichtung nach Anspruch 29, wobei die Substratbewegungsvorrichtung ferner einen Schrittmotor (35) umfasst, der mit zumindest einer der ersten Steuerungsschraube (31), der zweiten Steuerungsschraube (33) und der dritten Steuerungsschraube (34) verbunden ist.

31. Vorrichtung nach Anspruch 27, ferner umfassend:
einen Stütz-Befestigungsrahmen (20), der das erste Substrat (8) und das Druckobjekt (4) von unten stützt.

32. Vorrichtung zum Ausbilden eines Musters umfassend:
ein erstes Substrat (8), das drehbar vorgesehen ist und eine Walzenform hat;
einen Beschichter (3), der eine Oberfläche des ersten Substrats (8) unter Verwendung einer Beschichtung (9, 9a, 9b, 9c, 9d) mit einer Ionenkomponente mit einer positiven oder negativen elektrischen Ladung beschichtet;
ein zweite Substrat (2) mit einer ersten Seite (2a) mit Vorsprüngen (2c), auf welche die Beschichtung (9, 9a, 9b, 9c, 9d), die auf das erste Substrat (8) aufgebracht ist, unter Verwendung des Beschichters (3) übertragen wird; und
eine Elektrode (6, 1), die an dem ersten Substrat (8) und dem zweiten Substrat (2) vorgesehen ist,
wobei das erste Substrat (8) rotiert wird, während es in Kontakt mit der ersten Seite (2a) des zweiten Substrats (2) ist, um die Beschichtung (9, 9a, 9b, 9c, 9d), die auf die Oberfläche des ersten Substrats (8) aufgebracht ist, auf die Vorsprünge (2c), die auf der ersten Seite (2a) des zweiten Substrats (2) ausgebildet sind, zu übertragen und die Beschichtung (9, 9a, 9b, 9c, 9d), die auf den Vorsprüngen (2c) des zweiten Substrats (2) aufgebracht ist, in Kontakt mit dem Druckobjekt (4) kommt, um die Beschichtung (9, 9a, 9b, 9c, 9d) auf das Druckobjekt (4) zu übertragen, wodurch das Muster auf dem Druckobjekt (4) ausgebildet wird, und
wobei die Elektrode (6, 1) eine erste Substratelektrode (6), die auf dem ersten Substrat (8) vorgesehen ist, und eine zweite Substratelektrode (1), die auf dem zweiten Substrat (2) vorgesehen ist, umfasst,
die Beschichtung (9, 9a, 9b, 9c, 9d) auf eine Oberfläche des ersten Substrats (8) unter Verwendung des Beschichters (3) entlang der Oberfläche des ersten Substrats (8) aufgebracht wird, während das erste Substrat (8) rotiert wird,
die zweite Substratelektrode (1) so elektrifiziert ist, dass sie die elektrische Ladung entgegengesetzt der elektrischen Ladung der Ionenkomponente der Beschichtung (9, 9a, 9b, 9c, 9d) hat, die auf der Oberfläche des ersten Substrats (8) ausgebildet ist, und das erste Substrat (8), auf dem die Beschichtung (9, 9a, 9b, 9c, 9d) aufgebracht ist, rotiert wird, während das erste Substrat (8) in Kontakt mit der ersten Seite (2a) des zweiten Substrats (2) ist, so dass das erste Substrat (8) entlang der Oberfläche der ersten Seite (2a) des zweiten Substrats (2) bewegt wird, wodurch die Beschichtung (3) von dem ersten Substrat (8) auf die Vorsprünge (2c) des zweiten Substrats (2) übertragen wird, und
die zweite Substratelektrode (1) so elektrifiziert ist, dass sie dieselbe elektrische Ladung wie die Ionenkomponente der Beschichtung (9, 9a, 9b, 9c, 9d) hat, die an den Vorsprüngen (2c) des zweiten Substrats (2) angebracht ist, so dass die Beschichtung (9, 9a, 9b, 9c, 9d), die auf den Vorsprüngen (2c) des zweiten Substrats (2) aufgebracht ist, auf das Druckobjekt (4) übertragen wird, wodurch das Muster auf dem Druckobjekt (4) ausgebildet wird,
**dadurch gekennzeichnet, dass**
die erste Substratelektrode (6) so elektrifiziert ist, dass sie dieselbe elektrische Ladung wie die Ionenkomponente der Beschichtung (9, 9a, 9b, 9c, 9d) hat, die auf die Oberfläche des ersten Substrats (8) aufgebracht ist.

33. Vorrichtung nach Anspruch 32, ferner umfassend:
eine Druckobjektelektrode (5), die auf dem Druckobjekt (4) vorgesehen ist,
wobei die Druckobjektelektrode (5) so elektrifiziert ist, dass sie die elektrische Ladung entgegengesetzt der elektrischen Ladung der Ionenkomponente der Beschichtung (9, 9a, 9b, 9c, 9d) hat, die an den Vorsprüngen (2c) des zweiten Substrats (2) angebracht ist, wenn das zweite Substrat (2) in Kontakt mit dem Druckobjekt (4) gelangt.

## Revendications

1. Procédé de formation d'un motif, le procédé comprenant les étapes suivantes :
a) l'application de revêtements (9, 9a, 9b, 9c, 9d) contenant un composant ionique ayant une charge électrique positive ou négative sur une première face (8a) d'un premier substrat (8) ;
b) la mise en contact de la première face (8a) du premier substrat (8) avec une partie irrégulière d'une première face (2a) d'un second substrat (2) afin de transférer une partie des revêtements (9, 9a, 9b, 9c, 9d) qui correspond aux saillies (2c) du second substrat (2) depuis le premier substrat (8) sur le second substrat (2) ; et
c) la mise en contact de la première face (2a) du second substrat (2) avec un objet d'impression (4) afin de transférer les revêtements (9, 9a, 9b, 9c, 9d) sur l'objet d'impression (4),
dans lequel une électrode (6, 1) est fournie sur une seconde face (8b, 2b) du premier substrat (8) et du second substrat (2), qui est opposée à la première face (8a, 2a) du substrat (8, 2),
dans lequel l'électrode (1) sur le second substrat (2) est électrifiée de façon à avoir la charge électrique opposée à la charge électrique du composant ionique des revêtements (9, 9a, 9b, 9c, 9d) dans l'étape (b) et/ou de façon à avoir la même charge électrique que le composant ionique des revêtements (9, 9a, 9b, 9c, 9d) dans l'étape (c), et
dans lequel une électrode d'objet d'impression (5) est fournie sur une autre face de l'objet d'impression (4) qui est opposée à une face de l'objet d'impression (4) sur laquelle un motif est formé, et est électrifiée de façon à avoir la charge électrique opposée à la charge électrique du composant ionique des revêtements (9, 9a, 9b, 9c, 9d) dans l'étape (c),
**caractérisé en ce que**
l'électrode (6) sur le premier substrat (8) est électrifiée de façon à avoir la même charge électrique que le composant ionique des revêtements (9, 9a, 9b, 9c, 9d) dans l'étape (b).

2. Procédé de formation d'un motif de revêtements (9, 9a, 9b, 9c, 9d), le procédé comprenant les étapes suivantes :
a) le remplissage des revêtements (9, 9a, 9b, 9c, 9d) contenant un composant ionique ayant une charge électrique positive ou négative dans une rainure d'une première face (8a) d'un premier substrat (8) ;
b) la mise en contact d'une première face (2a) d'un second substrat (2) avec la première face (8a) du premier substrat (8) afin de transférer les revêtements (9, 9a, 9b, 9c, 9d) contenus dans la rainure du premier substrat (8) sur le second substrat (2) ; et
c) la mise en contact de la première face (2a) du second substrat (2) avec un objet d'impression (4) afin de transférer les revêtements (9, 9a, 9b, 9c, 9d) depuis le second substrat (2) sur l'objet d'impression (4),
dans lequel une électrode (6, 1) est fournie sur une seconde face (8b, 2b) du premier substrat (8) et du second substrat (2), qui est opposée à la première face (8a, 2a) du substrat (8, 2),
dans lequel l'électrode (1) sur le second substrat (2) est électrifiée de façon à avoir la charge électrique opposée à la charge électrique du composant ionique des revêtements (9, 9a, 9b, 9c, 9d) dans l'étape (b) et/ou de façon à avoir la même charge électrique que le composant ionique des revêtements (9, 9a, 9b, 9c, 9d) dans l'étape (c),
dans lequel une électrode d'objet d'impression (5) est fournie sur une autre face de l'objet d'impression (4) qui est opposée à une face de l'objet d'impression (4) sur laquelle un motif est formé, et est électrifiée de façon à avoir la charge électrique opposée à la charge électrique du composant ionique des revêtements (9, 9a, 9b, 9c, 9d) dans l'étape (c),
**caractérisé en ce que**
l'électrode (6) sur le premier substrat (8) est électrifiée de façon à avoir la même charge électrique que le composant ionique des revêtements (9, 9a, 9b, 9c, 9d) dans l'étape (b).

3. Procédé selon la revendication 1 ou 2,
dans lequel le premier substrat (8) est formé de l'un quelconque parmi un matériau de caoutchouc de silicium, un matériau de plastique dur, et un matériau de verre.

4. Procédé selon la revendication 1 ou 2,
dans lequel une surface du premier substrat (8) est reformée avant l'étape (a), par l'un quelconque parmi les procédés de revêtement de surface consistant à revêtir la surface du premier substrat (8) au moyen d'un matériau hydrophobe et un procédé de traitement hydrophobe de surface de la surface du premier substrat (8) au moyen d'un plasma.

5. Procédé selon la revendication 1 ou 2,
dans lequel le second substrat (2) est formé de l'un quelconque parmi un métal, un matériau de plastique dur, et un composé de silicium.

6. Procédé selon la revendication 1,
dans lequel au moins une parmi la première électrode de substrat (6) sur le premier substrat (8) et la seconde électrode de substrat (1) sur le second substrat (2) a la forme correspondant à la partie irrégulière de la première face (2a) du second substrat (2).

7. Procédé selon la revendication 1 ou 2,
dans lequel l'objet d'impression (4) est formé de l'un quelconque parmi un matériau de verre, un matériau de plastique flexible, et un matériau de plastique dur.

8. Procédé selon la revendication 1,
dans lequel une électrode d'objet d'impression (5) est fournie sur une autre face de l'objet d'impression (4) qui est opposée à une face de l'objet d'impression (4) sur laquelle un motif est formé, et a la forme correspondant à la partie irrégulière de la première face (2a) du second substrat (2)

9. Procédé selon la revendication 1 ou 2,
dans lequel au moins un parmi le premier substrat (8) et le second substrat (2) a une forme de plaque plate ou de rouleau.

10. Procédé selon la revendication 1 ou 2,
dans lequel le premier substrat (8) et le second substrat (2) sont fixés aux premières faces d'un premier support de substrat (7) et d'un second support de substrat (13), et la première électrode de substrat (6) sur le premier substrat (8) et la seconde électrode de substrat (1) sur le second substrat (2) sont fournies sur les secondes faces du premier support de substrat (7) et du second support de substrat (13) qui sont opposées aux premières faces du premier support de substrat (7) et du second support de substrat (13).

11. Procédé selon la revendication 10,
dans lequel le premier substrat (8) et le second substrat (2) sont fixés au premier support de substrat (7) et au second support de substrat (13) sous vide.

12. Procédé selon la revendication 1 ou 2,
dans lequel le contact dans l'étape (b) ou le contact dans l'étape (c) est contrôlé en utilisant un procédé de détection par compression électrique et optique pour appliquer une pression uniforme sur une surface de contact entière.

13. Procédé selon la revendication 12,
dans lequel le procédé de détection par compression électrique et optique est mise en oeuvre au moyen d'un capteur piézo-diélectrique ou d'un interféromètre laser.

14. Procédé selon la revendication 1, comprenant en outre les étapes suivantes :
d) la mise en contact des revêtements (9, 9a, 9b, 9c, 9d) restant sur le premier substrat (8) ou le second substrat (2) avec une première face d'un substrat de nettoyage (11) afin d'éliminer les revêtements (9, 9a, 9b, 9c, 9d) du premier substrat (8) ou du second substrat (2).

15. Procédé selon la revendication 14,
dans lequel une électrode de substrat de nettoyage (10) est fournie sur une seconde face du substrat de nettoyage (11) qui est opposée à la première face du substrat de nettoyage (11), et est électrifiée de façon à avoir la charge électrique opposée à la charge électrique du composant ionique des revêtements (9, 9a, 9b, 9c, 9d) restant sur le premier substrat (8) ou le second substrat (2).

16. Procédé selon la revendication 14,
dans lequel le substrat de nettoyage (11) est formé de l'un quelconque parmi un matériau inorganique, un matériau de plastique dur, et du verre.

17. Procédé selon la revendication 1 ou 2,
dans lequel les revêtements (9, 9a, 9b, 9c, 9d) de l'étape (a) sont une composition comprenant 50 à 95 % en poids d'un matériau électronique ; et 5 à 50 % en poids d'un composant cationique ou anionique,
dans lequel le matériau électronique est choisi dans le groupe constitué par une encre optique, une solution de métal pour fils, une pâte conductrice, une réserve, un adhésif, et une colle,
dans lequel le composant cationique ou le composant anionique est un ou plusieurs choisis dans le groupe constitué par un polymère qui est polymérisé en utilisant des monomères cationiques ou anioniques monovalents ou divalents ; un polymère liant choisi dans le groupe constitué par un copolymère qui est polymérisé en utilisant des monomères non ioniques et des monomères cationiques ou anioniques monovalents ou divalents, et un dérivé de celui-ci ; un tensioactif organique ou inorganique contenant des composants cationiques ou anioniques monovalents ou divalents ; et un colorant cationique ou anionique monovalent ou divalent, un pigment cationique ou anionique monovalent ou divalent, et un complexe de ceux-ci.

18. Procédé selon la revendication 1,
dans lequel le motif formé avec le revêtement est utilisé dans un dispositif électronique.

19. Procédé selon la revendication 18,
dans lequel le dispositif électronique est compris dans un appareil électronique.

20. Appareil de formation d'un motif comprenant :
un premier substrat (8) ;
un dispositif d'enduction (3) fourni de telle manière que le dispositif d'enduction (3) soit capable d'être déplacé le long d'une première face (8a) du premier substrat (8) par un dispositif de déplacement de dispositif d'enduction afin de revêtir la première face (8a) du premier substrat (8) en utilisant les revêtements (9, 9a, 9b, 9c, 9d) contenant un composant ionique ayant une charge électrique positive ou négative ;
un second substrat (2) fourni de telle manière que le second substrat (2) soit capable d'être déplacé dans le sens des axes z, x, y et θ basés sur une surface du substrat (2) par un dispositif de déplacement de substrat afin de venir en contact avec la première face (8a) du premier substrat (8) et comportant des saillies (2c), qui sont formées sur une première face (2a) du second substrat (2), sur lesquelles les revêtements (9, 9a, 9b, 9c, 9d) appliqués sur la première face (8a) du premier substrat (8) sont transférés au moyen du dispositif d'enduction (3) ; et
une électrode (6, 1) fournie sur le premier substrat (8) et le second substrat (2), dans lequel la première face (2a) du second substrat (2) vient au contact d'un objet d'impression (4) afin de transférer les revêtements (9, 9a, 9b, 9c, 9d) sur l'objet d'impression (4), pour ainsi former le motif sur l'objet d'impression (4), et
dans lequel l'électrode (6, 1) comprend une première électrode de substrat (6) fournie sur la seconde face (8b) du premier substrat (8) et une seconde électrode de substrat (1) fournie sur une seconde face (2b) du second substrat (2),
le second substrat (2) est déplacé afin que les saillies (2c) formée sur la première face (2a) du second substrat (2) viennent au contact des revêtements (9, 9a, 9b, 9c, 9d) appliqués sur la première face (8a) du premier substrat (8) au moyen du dispositif d'enduction (3),
dans lequel la seconde électrode de substrat (1) est électrifiée de façon à avoir la charge électrique opposée à la charge électrique du composant ionique des revêtements (9, 9a, 9b, 9c, 9d) appliqués sur la première face (8a) du premier substrat (8), pour ainsi transférer les revêtements (9, 9a, 9b, 9c, 9d) qui sont appliqués sur la première face (8a) du premier substrat (8) sur les saillies (2c) formées sur la première face (2a) du second substrat (2), et
la seconde électrode de substrat (1) est électrifiée de façon à avoir la même charge électrique que le composant ionique des revêtements (9, 9a, 9b, 9c, 9d) fixés aux saillies (2c) du second substrat (2) afin que les revêtements (9, 9a, 9b, 9c, 9d) fixés aux saillies (2c) du second substrat (2) soient transférés sur l'objet d'impression (4), pour ainsi former le motif sur l'objet d'impression (4),
**caractérisé en ce que** la première électrode de substrat (6) est électrifiée de façon à avoir la même charge électrique que le composant ionique des revêtements (9, 9a, 9b, 9c, 9d) appliqués sur la première face (8a) du premier substrat (8).

21. Appareil selon la revendication 20, comprenant en outre :
une électrode d'objet d'impression (5) fournie sur l'objet d'impression (4),
dans lequel l'électrode d'objet d'impression (5) est électrifiée de façon à avoir la charge électrique opposée à la charge électrique du composant ionique des revêtements (9, 9a, 9b, 9c, 9d) fixés aux saillies (2c) du second substrat (2) quand la première face (2a) du second substrat (2) vient au contact de l'objet d'impression (4).

22. Appareil selon la revendication 20,
dans lequel l'appareil de déplacement de substrat comprend :
un premier dispositif de déplacement qui comprend un cadre de support de déplacement (32) servant à guider le déplacement du second substrat (2), et une première vis de commande (31) fournie dans le cadre de support de déplacement (32) pour commander le déplacement du second substrat (2) dans le sens d'un axe z par rapport à une surface du second substrat (2) ; et
un second dispositif de déplacement qui comprend une deuxième vis de commande (33) et une troisième vis de commande (34) fournies dans le second substrat (2) pour commander le déplacement du second substrat (2) dans le sens d'un axe x, d'un axe y et d'un axe θ le long d'une direction de surface du second substrat (2).

23. Appareil selon la revendication 22,
dans lequel le dispositif de déplacement de substrat comprend en outre un moteur pas-à-pas (35) qui est raccordé à au moins une vis de commande parmi la première vis de commande (31), la deuxième vis de commande (33), et la troisième vis de commande (34).

24. Appareil selon la revendication 20, dans lequel le dispositif de déplacement de dispositif d'enduction comprend :
un cadre de montage de dispositif d'enduction (40) sur lequel le dispositif d'enduction (3) est monté ; et
un moteur linéaire (41) qui déplace le cadre de montage de dispositif d'enduction (40) sur lequel le dispositif d'enduction (3) est monté à droite et à gauche.

25. Appareil selon la revendication 20, comprenant en outre :
un cadre de fixation de support (20) qui supporte le premier substrat (8) et l'objet d'impression (4) par le bas.

26. Appareil selon la revendication 20, comprenant en outre :
un substrat de nettoyage (11) fourni afin d'être capable de venir à proximité du premier substrat (8) et d'être séparé du premier substrat (8) quand les revêtements (9, 9a, 9b, 9c, 9d) fixés aux saillies (2c) du second substrat (2) sont transférés sur l'objet d'impression (4), pour ainsi éliminer les revêtements (9, 9a, 9b, 9c, 9d) restant sur la première face (8a) du premier substrat (8).

27. Appareil de formation d'un motif comprenant :
un premier substrat (8) ayant une première face (8a) sur laquelle une rainure dans laquelle des revêtements (9, 9a, 9b, 9c, 9d) contenant un composant ionique ayant une charge électrique positive ou négative sont contenus est formée ;
un second substrat (2) fourni de telle manière que le second substrat (2) soit capable d'être déplacé dans le sens des axes z, x, y et θ basés sur une surface du substrat (2) par un dispositif de déplacement de substrat afin de venir en contact avec la première face (8a) du premier substrat (8), le second substrat (2) ayant une première face (2a) sur laquelle les revêtements (9, 9a, 9b, 9c, 9d) contenus dans la rainure du premier substrat (8) sont transférés ; et
une électrode (6, 1) fournie sur le premier substrat (8) et le second substrat (2),
dans lequel les revêtements (9, 9a, 9b, 9c, 9d) contenus dans la rainure du premier substrat (8) sont transférés sur la première face (2a) du second substrat (2), et la première face (2a) du second substrat (2) vient au contact de l'objet d'impression (4) afin de transférer les revêtements (9, 9a, 9b, 9c, 9d) sur l'objet d'impression (4), pour ainsi former le motif sur l'objet d'impression (4),
dans lequel l'électrode (6, 1) comprend une première électrode de substrat (6) fournie sur une seconde face (8b) du premier substrat (8), et une seconde électrode de substrat (1) fournie sur une seconde face (2b) du second substrat (2), le second substrat est déplacé afin que la première face (2a) du second substrat (2) vienne au contact des revêtements (9, 9a, 9b, 9c, 9d) contenus dans la rainure formée sur la première face (8a) du premier substrat (8),
la seconde électrode de substrat (1) est électrifiée de façon à avoir la charge électrique opposée à la charge électrique du composant ionique des revêtements (9, 9a, 9b, 9c, 9d) contenus dans la rainure formée sur la première face (8a) du premier substrat (8), pour ainsi transférer les revêtements (9, 9a, 9b, 9c, 9d) qui sont contenus dans la rainure formée sur la première face (8a) du premier substrat (8) sur la première face (2a) du second substrat (2), et
la seconde électrode de substrat (1) est électrifiée de façon à avoir la même charge électrique que le composant ionique des revêtements (9, 9a, 9b, 9c, 9d) fixés à la première face (2a) du second substrat (2) afin que les revêtements (9, 9a, 9b, 9c, 9d) fixés à la première face (2a) du second substrat (2) soient transférés sur l'objet d'impression (4), pour ainsi former le motif sur l'objet d'impression (4),
**caractérisé en ce que**
la première électrode de substrat (6) est électrifiée de façon à avoir la même charge électrique que le composant ionique des revêtements (9, 9a, 9b, 9c, 9d) contenus dans la rainure formée sur la première face du premier substrat (8).

28. Appareil selon la revendication 27, comprenant en outre :
une électrode d'objet d'impression (5) fournie sur l'objet d'impression (4),
dans lequel l'électrode d'objet d'impression (5) est électrifiée de façon à avoir la charge électrique opposée à la charge électrique du composant ionique des revêtements (9, 9a, 9b, 9c, 9d) fixés à la première face (2a) du second substrat (2) quand la première face (2a) du second substrat (2) vient au contact de l'objet d'impression (4).

29. Appareil selon la revendication 27, dans lequel le dispositif de déplacement de substrat comprend :
un premier dispositif de déplacement qui comprend un cadre de support de déplacement (32) servant à guider le déplacement du second substrat (2), et une première vis de commande (31) fournie dans le cadre de support de déplacement (32) pour commander le déplacement du second substrat (2) dans le sens d'un axe z par rapport à une surface du second substrat (2) ; et
un second dispositif de déplacement qui comprend une deuxième vis de commande (33) et une troisième vis de commande (34) fournies dans le second substrat (2) pour commander le déplacement du second substrat (2) dans le sens d'un axe x, d'un axe y et d'un axe θ le long d'une direction de surface du second substrat (2).

30. Appareil selon la revendication 29,
dans lequel le dispositif de déplacement de substrat comprend en outre un moteur pas-à-pas (35) qui est raccordé à au moins une vis de commande parmi la première vis de commande (31), la deuxième vis de commande (33), et la troisième vis de commande (34).

31. Appareil selon la revendication 27, comprenant en outre :
un cadre de fixation de support (20) qui supporte le premier substrat (8) et l'objet d'impression (4) par le bas.

32. Appareil de formation d'un motif comprenant :
un premier substrat (8) qui est fourni rotatif et qui possède une forme de rouleau ;
un dispositif d'enduction (3) qui enduit une surface du premier substrat (8) au moyen de revêtements (9, 9a, 9b, 9c, 9d) contenant un composant ionique ayant une charge électrique positive ou négative ;
un second substrat (2) ayant une première face (2a), avec des saillies (2c) sur lesquelles les revêtements (9, 9a, 9b, 9c, 9d) appliqués sur le premier substrat (8) sont transférés au moyen du dispositif d'enduction (3) ; et
une électrode (6, 1) fournie sur le premier substrat (8) et le second substrat (2),
dans lequel le premier substrat (8) est mis en rotation tout en étant en contact avec la première face (2a) du second substrat (2) afin de transférer les revêtements (9, 9a, 9b, 9c, 9d) appliqués sur la surface du premier substrat (8) sur les saillies (2c) formées sur la première face (2a) du second substrat (2), et les revêtements (9, 9a, 9b, 9c, 9d) fixés aux saillies (2c) du second substrat (2) viennent au contact de l'objet d'impression (4) afin de transférer les revêtements (9, 9a, 9b, 9c, 9d) sur l'objet d'impression (4), pour ainsi former le motif sur l'objet d'impression (4), et
dans lequel l'électrode (6,1) comprend une première électrode de substrat (6) fournie sur le premier substrat (8), et une seconde électrode de substrat (1) fournie sur le second substrat (2),
les revêtements (9, 9a, 9b, 9c, 9d) sont appliqués, sur une surface du premier substrat (8) au moyen du dispositif d'enduction (3), le long de la surface du premier substrat (8) tandis que le premier substrat (8) est en rotation,
la seconde électrode de substrat (1) est électrifiée de façon à avoir la charge électrique opposée à la charge électrique du composant ionique des revêtements (9, 9a, 9b, 9c, 9d) formés sur la surface du premier substrat (8), et le premier substrat (8) sur lequel les revêtements (9, 9a, 9b, 9c, 9d) sont appliqués est mis en rotation tandis que le premier substrat (8) est en contact avec la première face (2a) du second substrat (2) de sorte que le premier substrat (8) est déplacé le long de la surface de la première face (2a) du second substrat (2), pour ainsi transférer les revêtements (3) depuis le premier substrat (8) sur les saillies (2c) du second substrat (2), et
la seconde électrode de substrat (1) est électrifiée de façon à avoir la même charge électrique que le composant ionique des revêtements (9, 9a, 9b, 9c, 9d) fixés aux saillies (2c) du second substrat (2) afin que les revêtements (9, 9a, 9b, 9c, 9d) fixés aux saillies (2c) du second substrat (2) soient transférés sur l'objet d'impression (4), pour ainsi former le motif sur l'objet d'impression (4),
**caractérisé en ce que**
la première électrode de substrat (6) est électrifiée de façon à avoir la même charge électrique que le composant ionique des revêtements (9, 9a, 9b, 9c, 9d) appliqués sur la surface du premier substrat (8).

33. Appareil selon la revendication 32, comprenant en outre :
une électrode d'objet d'impression (5) fournie sur l'objet d'impression (4),
dans lequel l'électrode d'objet d'impression (5) est électrifiée de façon à avoir la charge électrique opposée à la charge électrique du composant ionique des revêtements (9, 9a, 9b, 9c, 9d) fixés aux saillies (2c) du second substrat (2) quand le second substrat (2) vient au contact de l'objet d'impression (4).
